(19)

Europäisches
Patentamt

European
Patent Office

Office européen
des brevets

(11) **EP 4 150 465 B1**

(12) **EUROPEAN PATENT SPECIFICATION**

(45) Date of publication and mention
of the grant of the patent:
**16.04.2025  Bulletin 2025/16**

(21) Application number: **21730899.8**

(22) Date of filing: **03.06.2021**

(51) International Patent Classification (IPC):
**G06F 11/36** (2025.01)      **G05D 1/00** (2024.01)
**G05B 13/04** (2006.01)     **B60W 50/00** (2006.01)
**G05B 17/02** (2006.01)
**G06F 30/15** (2020.01)      **G06F 30/20** (2020.01)

(52) Cooperative Patent Classification (CPC):
**G06F 11/3684; G06F 11/3668; G06F 11/3692;**
**B60W 2050/0018; G05B 17/02; G06F 30/15;**
**G06F 30/20**

(86) International application number:
**PCT/EP2021/064937**

(87) International publication number:
**WO 2021/245200 (09.12.2021 Gazette 2021/49)**

(54) **SIMULATION IN AUTONOMOUS DRIVING**

SIMULATION BEIM AUTONOMEN FAHREN

SIMULATION EN CONDUITE AUTONOME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **03.06.2020  GB 202008353**

(43) Date of publication of application:
**22.03.2023  Bulletin 2023/12**

(73) Proprietor: **Five AI Limited
Cambridge CB1 2JH (GB)**

(72) Inventors:
• **REDFORD, John**
**Temple Meads Bristol BS1 6QS (GB)**
• **ANTONELLO, Morris**
**Temple Meads Bristol BS1 6QS (GB)**
• **LYONS, Simon**
**Temple Meads Bristol BS1 6QS (GB)**
• **PENKOV, Svet**
**Temple Meads Bristol BS1 6QS (GB)**
• **RAMAMOORTHY, Subramanian**
**Temple Meads Bristol BS1 6QS (GB)**

(74) Representative: **Page White Farrer
Bedford House
21a John Street
London WC1N 2BF (GB)**

(56) References cited:
**WO-A2-2020/079069**

• **STEFANO V ALBRECHT ET AL: "Integrating
Planning and Interpretable Goal Recognition for
Autonomous Driving", ARXIV.ORG, CORNELL
UNIVERSITY LIBRARY, 201 OLIN LIBRARY
CORNELL UNIVERSITY ITHACA, NY 14853, 6
February 2020 (2020-02-06), XP081593753**
• **GALCERAN ENRIC ET AL: "Multipolicy decision-
making for autonomous driving via changepoint-
based behavior prediction: Theory and
experiment", AUTONOMOUS ROBOTS, KLUWER
ACADEMIC PUBLISHERS, DORDRECHT, NL, vol.
41, no. 6, 9 February 2017 (2017-02-09), pages
1367 - 1382, XP036268382, ISSN: 0929-5593,
[retrieved on 20170209], DOI: 10.1007/
S10514-017-9619-Z**

## Description

<u>Technical Field</u>

The present disclosure pertains to simulation in the context of autonomous driving, and in particular to techniques for generating driving scenarios that can be used as a basis for simulation. Simulation has various applications, including testing and training. Example applications of the present techniques include ADS (Autonomous Driving System) and ADAS (Advanced Driver Assist System) performance testing in an off-board context.

<u>Background</u>

There have been major and rapid developments in the field of autonomous vehicles. An autonomous vehicle is a vehicle which is equipped with sensors and control systems which enabled it to operate without a human controlling its behaviour. An autonomous vehicle is equipped with sensors which enable it to perceive its physical environment, such sensors including for example cameras, radar and lidar. Autonomous vehicles (AVs) are equipped with suitably programmed computers which are capable of processing data received from the sensors and making safe and predictable decisions based on the context which has been perceived by the sensors. There are different facets to testing the behaviour of the sensors and control systems aboard a particular autonomous vehicle, or a type of autonomous vehicle.

A "level 5" vehicle is one that can operate entirely autonomously in any circumstances, because it is always guaranteed to meet some minimum level of safety. Such a vehicle would not require manual controls (steering wheel, pedals etc.) at all.

By contrast, level 3 and level 4 vehicles can operate fully autonomously but only within certain defined circumstances (e.g. within geofenced areas). A level 3 vehicle must be equipped to autonomously handle any situation that requires an immediate response (such as emergency braking); however, a change in circumstances may trigger a "transition demand", requiring a driver to take control of the vehicle within some limited timeframe. A level 4 vehicle has similar limitations; however, in the event the driver does not respond within the required timeframe, a level 4 vehicle must also be capable of autonomously implementing a "minimum risk maneuver" (MRM), i.e. some appropriate action(s) to bring the vehicle to safe conditions (e.g. slowing down and parking the vehicle). A level 2 vehicle requires the driver to be ready to intervene at any time, and it is the responsibility of the driver to intervene if the autonomous systems fail to respond properly at any time. With level 2 automation, it is the responsibility of the driver to determine when their intervention is required; for level 3 and level 4, this responsibility shifts to the vehicle's autonomous systems and it is the vehicle that must alert the driver when intervention is required.

Safety is an increasing challenge as the level of autonomy increases and more responsibility shifts from human to machine. In autonomous driving, the importance of guaranteed safety has been recognized. Guaranteed safety does not necessarily imply zero accidents, but rather means guaranteeing that some minimum level of safety is met in defined circumstances. It is generally assumed this minimum level of safety must significantly exceed that of human drivers for autonomous driving to be viable.

According to Shalev-Shwartz et al. "On a Formal Model of Safe and Scalable Self-driving Cars" (2017), arXiv:1708.06374 (the RSS Paper), human driving is estimated to cause of the order $10^{-6}$ severe accidents per hour. On the assumption that autonomous driving systems will need to reduce this by at least three order of magnitude, the RSS Paper concludes that a minimum safety level of the order of $10^{-9}$ severe accidents per hour needs to be guaranteed, noting that a pure data-driven approach would therefore require vast quantities of driving data to be collected every time a change is made to the software or hardware of the AV system.

The RSS paper provides a model-based approach to guaranteed safety. A rule-based Responsibility-Sensitive Safety (RSS) model is constructed by formalizing a small number of "common sense" driving rules:

"1. Do not hit someone from behind.

2. Do not cut-in recklessly.

3. Right-of-way is given, not taken.

4. Be careful of areas with limited visibility.

5. If you can avoid an accident without causing another one, you must do it."

The RSS model is presented as provably safe, in the sense that, if all agents were to adhere to the rules of the RSS model at all times, no accidents would occur. The aim is to reduce, by several orders of magnitude, the amount of driving data that needs to be collected in order to demonstrate the required safety level.

A safety model (such as RSS) can be used as a basis for evaluating the quality of trajectories that are planned or realized by an ego agent in a real or simulated scenario under the control of an autonomous system (stack). The stack is tested by exposing it to different scenarios, and evaluating the resulting ego trajectories for compliance with rules of the safety model (rules-based testing). A rules-based testing approach can also be applied to other facets of performance, such as comfort or progress towards a defined goal.

Sensor processing may be evaluated in real-world physical facilities. Similarly, the control systems for autonomous vehicles may be tested in the physical world, for example by repeatedly driving known test routes, or by driving routes with a human on-board to manage unpredictable or unknown contexts.

Physical world testing will remain an important factor in the testing of autonomous vehicles capability to make safe and predictable decisions. However, physical world testing is expensive and time-consuming. Increasingly there is more reliance placed on testing using simulated environments. Autonomous vehicles need to have the facility to operate in the same wide variety of circumstances that a human driver can operate in. Such circumstances can incorporate a high level of unpredictability.

It is not viable to achieve from physical testing a test of the behaviour of an autonomous vehicle in all possible scenarios that it may encounter in its driving life. Increasing attention is being placed on the creation of simulation environments which can provide such testing in a manner that gives confidence that the test outcomes represent potential real behaviour of an autonomous vehicle.

A simulator is a computer program which when executed by a suitable computer enables an AV stack to be developed and tested in simulation. A simulator provides appropriate simulated perception inputs on which the AV stack operates. A simulator also provides a two-dimensional or three-dimensional environmental model which reflects the physical environment that an automatic vehicle may operate in. The 3-D environmental model defines at least the road network on which an autonomous vehicle is intended to operate, and other actors (agents) in the environment. In addition to modelling the behaviour of the ego vehicle, the behaviour of these actors also needs to be modelled.

Simulation environments need to be able to represent real-world factors that may change in the road layout in which it is navigating. This can include weather conditions, road types, road structures, junction types etc. This list is not exhaustive, as there are many factors that may affect the operation of an ego vehicle. A complex AV stack can be highly sensitive to small changes in road layout, environmental conditions, or a particular combination of factors might result in failure in a way that is very hard to predict.

International Patent Publication No. WO 2020/079069 discloses a method of analysing driving behaviour in a data processing computer system, the method comprising analysing driving behaviour data to determine a normal behaviour model for a driving area, and identifying abnormal driving trajectories.

STEFANO V ALBRECHT ET AL, "Integrating Planning and Interpretable Goal Recognition for Autonomous Driving", ARXIV.ORG, CORNELL UNIVERSITY LIBRARY, 201 OLIN LIBRARY CORNELL UNIVERSITY ITHACA, NY 14853, (20200206), teaches an integrated planning and prediction system which uses a finite space of manoeuvres and inverse planning to recognise the goals of other vehicles.

GALCERAN ENRIC ET AL, "Multipolicy decision-making for autonomous driving via changepoint-based behavior prediction: Theory and experiment", AUTONOMOUS ROBOTS, KLUWER ACADEMIC PUBLISHERS, DORDRECHT, NL, vol. 41, no. 6, doi:10.1007/S10514-017-9619-Z, ISSN 0929-5593, (20170209), pages 1367 - 1382, (20170209), teaches an integrated inference and decision-making approach for autonomous driving that models vehicle behaviour for both a vehicle and nearby vehicles as a discrete set of closed-loop policies.

Reference is additionally made to the following:

[10] C. G'amez Serna and Y. Ruichek. Dynamic speed adap-tation for path tracking based on curvature information and speed limits. Sensors, 17(1383), 2017.

[12] P. Hart, N. Nilsson, and B. Raphael. A formal basis for the heuristic determination of minimum cost paths. In IEEE Transactions on Systems Science and Cybernetics, volume 4, pages 100-107, July 1968.

[19] S. Niekum, S. Osentoski, C. Atkeson, and A. Barto. Online Bayesian changepoint detection for articulated motion models. In IEEE International Conference on Robotics and Automation. IEEE, 2015.

[27] A. Wachter and L. Biegler. On the implementation of an interior-point filter line-search algorithm for large-scale nonlinear programming. Mathematical Programming, 106 (1):25-57, 2006.

Summary

One approach is to run simulations based on real-world data, where the aim is to re-create (and potentially modify) real-world scenarios in a simulator.

It is relatively straightforward to re-create observed agent "traces" in a simulator, given adequate real-world driving data (a trace being a history of an agent's location and motion over the course of a driving run). Simple "open-loop" simulation of other agent(s) simply recreates observed agent traces in a simulator, but does not implement reactive or autonomous behaviour of the other agent(s) in the scenarios. That is, whilst the AV stack reacts autonomously to other agent(s) in the simulation, the other agent(s) do not react to the ego vehicle. In this context, the traces of the other agent(s) are simply "replayed" for the AV stack to respond to.

However, using real-world driving data as a basis for "closed-loop" simulations presents a much greater challenge. In the present context, "closed-loop" simulation refers to autonomous, reactive behaviour of the other agent(s). That is, not only does the ego agent respond to the other agent(s), the other agent(s) also implement some degree of autonomous, reactive behaviour. When simulating based on agent traces observed in the real-world, it is no longer simply a case of replaying those traces in a simulator; some way is needed to implement the necessary layers of autonomous decision logic.

Herein, techniques are provided for automatically deriving driving scenarios from real-world driving data (such as on-board sensor data, closed circuit television data etc.) that are closed-loop in the above sense.

According to a first aspect herein, a computer system for testing an autonomous vehicle (AV) stack in simulation, comprises:

> a trace extraction component configured to processing real-world driving data to extract therefrom at least one observed trace of a real-world agent within a road layout, the observed trace having spatial and motion components;
> a driving scenario extraction component configured to apply at least one of goal recognition and behaviour recognition to the observed trace, to infer a goal or behaviour of the real-world agent within the road layout, and extract a driving scenario defining a version of the road layout and at least one non-ego agent to be simulated, the non-ego agent associated with the inferred goal or behaviour for implementing in simulation within the defined road layout;
> a simulator configured to run a simulation based on the extracted driving scenario, in which an ego agent and the non-ego agent each exhibit closed-loop behaviour, wherein the closed-loop behaviour of the ego agent is determined by autonomous decisions taken in the AV stack under testing in response to simulated inputs, reactive to the non-ego agent;
> agent decision logic configured to determine the closed-loop behaviour of the non-ego agent in the simulation, by implementing the inferred goal or behaviour, reactive to the ego agent; and
> a test oracle configured to evaluate the performance of the AV stack in the simulation, by receiving a simulated ego trace of the ego agent, as generated in the simulation, and scoring the simulated ego trace against a set of predetermined performance metrics.

In embodiments, the test oracle may be configured to provide an output comprising a score-time plot for each performance metric.

The performance metrics may be numerical and the test oracle may be configured compare the score-time plot to a failure threshold.

The agent decision logic may be configured to determine the closed-loop behaviour of the non-ego agent with the aim of matching target motion values along a spatial agent path, but with deviation from the target motion values permitted in reaction to the ego agent, the spatial agent path associated with the inferred goal or behaviour.

The driving scenario extraction component may be configured to infer the goal or behaviour probabilistically as a distribution over available (possible) goals or behaviours.

The driving scenario extraction component may be configured to infer the goal or behaviour probabilistically by:

> determining the set of available goals or behaviours for the real-world agent;
> for each of the available goals or behaviours, determining an expected trajectory model; and
> comparing the observed trace of the real-world agent with the expected trajectory model for each of the available goals or behaviours, to determine a likelihood of that goal or behaviour, thus determining a distribution over the available goals or behaviours.

The available goals or behaviours may be determined from the road layout.

The expected trajectory model may be a single predicted trajectory associated with that goal or behaviour or a distribution of predicted trajectories associated with that goal or behaviour.

The driving scenario extraction component may be configured to use the observed trace to predict a best-available trajectory model for the goal or behaviour, the above comparison comprising comparing the best-available trajectory model with the expected trajectory model.

A defined reward function may be applied to both the expected trajectory model and the best-available trajectory model for each goal, to determine respective rewards of those trajectory models, wherein the above comparison comprises comparing those rewards.

A reward function may equally be described as a cost function with no change in meaning.

The reward function may reward reduced driving time whilst penalizing unsafe trajectories.

The computer system may comprise a sampling component configured to sample a goal or behaviour from the distribution over the possible goals or behaviours, and the agent decision logic may be configured to determine the closed-loop behaviour of the non-ego agent based on the sampled goal or behaviour.

The computer system may comprise a rendering component configured to generate a graphical user interface comprising an output provided by the test oracle for assessing the performance of the AV stack in the simulation.

The above test oracle may be configured to score the simulated ego trace against the set of predetermined performance metrics in dependence on a simulated non-ego trace of the non-ego agent.

The test oracle may be configured to score the simulated ego trace against the set of predetermined performance metrics in dependence on environmental data of the simulation or other contextual data pertaining to a physical context of the simulation.

The trace extraction component may be configured to apply one or more non-real time perception algorithms to the real-world driving data, in order to extract the observed trace.

The agent decision logic may be tuned so as to cause the non-ego agent to realize a trajectory that substantially corresponds to the observed trace in the event the behaviour of the ego agent in the simulation substantially matches the behaviour of a real ego agent in the real-world driving data.

In embodiments, the driving scenario may define a spatial path for the agent, comprising or derived from the spatial components of the observed agent trajectory, the inferred goal or behaviour associated with the spatial path for autonomously implementing the goal or behaviour along the spatial path.

A goal or behaviour may be associated with a spatial path for implementing that goal or behaviour autonomously in simulation.

The motion components of the agent trajectory may, for example, be used to define target motion values along the spatial agent path, which the agent has the aim of matching, but is permitted to deviate when implementing the goal or behaviour autonomously.

A second aspect herein provides a computer-implemented method of testing an autonomous vehicle (AV) stack in simulation, the method comprising:

running, in a simulator, a simulation based on an extracted driving scenario, in which an ego agent and at least one non-ego agent each exhibit closed-loop behaviour, wherein the closed-loop behaviour of the ego agent is determined by autonomous decisions taken in the AV stack under testing in response to simulated inputs, reactive to the non-ego agent, wherein the closed-loop behaviour of the non-ego agent is determined by implementing an inferred goal or behaviour, reactive to the ego agent; and

evaluating, by a test oracle, the performance of the AV stack in the simulation, by receiving an ego trace of the ego agent, as generated in the simulation, and scoring the ego trace against a set of predetermined performance metrics the driving scenario having been extracted from real-world driving data captured within a road layout, by: processing the real-world driving data to extract at least one observed trace of a real-world agent, the observed trace having spatial and motion components, applying at least one of goal recognition and behaviour recognition to the observed trace, to infer the goal or behaviour of the real-world agent within the road layout, the extracted driving scenario defining a version of the road layout and at least one non-ego agent to be simulated, the non-ego agent associated with the inferred goal or behaviour for implementing in simulation within the defined version of the road layout.

The method may comprise using an output provided by the test oracle to identify and mitigate a performance issue within the AV stack under testing, the output for assessing the performance of the AV stack in the simulation.

The AV stack may comprise at least one trainable machine learning component, the method performed multiple times as part of a structured training process, wherein the performance of the AV stack is evaluated in each simulation, and that evaluation is used to train parameters of the machine learning component.

For example, the structured training process may be a reinforcement learning process, in which the parameters are trained based on a training cost or reward function applied to each simulation.

Further aspects provide a computer system comprising one or more computers programmed to carry out any of the method steps of system functions disclosed herein, and a computer program comprising program instructions for programming a computer system to implement the same.

Brief Description of Figures

For a better understanding of the present disclosure, and to show how embodiments of the same may be carried into effect, reference is made by way of example only to the following figures in which:

Figure 1A shows a schematic function block diagram of an autonomous vehicle stack;

Figure 1B shows a schematic overview of an autonomous vehicle testing paradigm;

Figure 1C shows a schematic block diagram of a scenario extraction pipeline that includes a goal recognition component applied to real-world traces in order to infer agent goal(s) to be implemented in subsequent closed-loop simulation;

Figure 2 shows a schematic block diagram of a testing pipeline;

Figure 2A shows further details of a possible implementation of the testing pipeline;

Figure 3A shows an example of a rule tree evaluated within a test oracle;

Figure 3B shows an example output of a node of a rule tree;

Figure 4A shows an example of a rule tree to be evaluated within a test oracle;

Figure 4B shows a second example of a rule tree evaluated on a set of scenario ground truth data;

Figure 4C shows how rules may be selectively applied within a test oracle;

Figure 5 shows a schematic block diagram of a visualization component for rendering a graphical user interface;

Figures 5A, 5B and 5C show different views available within a graphical user interface;

Figure 6A shows a first instance of a cut-in scenario;

Figure 6B shows an example oracle output for the first scenario instance;

Figure 6C shows a second instance of a cut-in scenario;

Figure 6D shows an example oracle output for the first scenario instance;

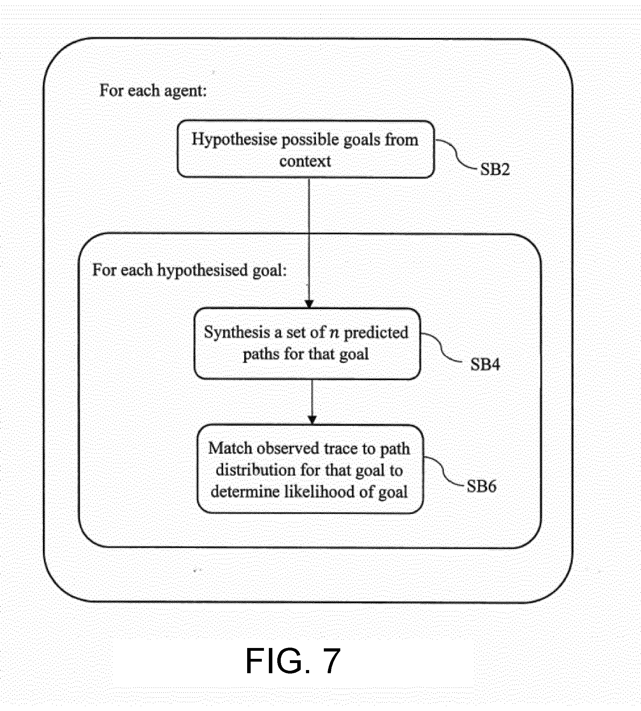

Figure 7 shows a flowchart for an inverse planning method;

Figures 8A-B illustrate certain principles of inverse planning by example;

Figure 9 shows further details of a possible implementation of a goal recognition component; and

Figure 10 shows a more detailed flowchart for an example implementation of an inverse planning method.

Detailed Description

I. OVERVIEW

The described embodiments provide a testing pipeline to facilitate rules-based testing of mobile robot stacks in real or simulated scenarios. Agent (actor) behaviour in real or simulated scenarios is evaluated by a test oracle based on defined performance evaluation rules. Such rules may evaluate different facets of safety. For example, a safety rule set may be defined to assess the performance of the stack against a particular safety standard, regulation or safety model (such as RSS), or bespoke rule sets may be defined for testing any aspect of performance. The testing pipeline is not limited in its application to safety, and can be used to test any aspects of performance, such as comfort or progress towards some defined goal. A rule editor allows performance evaluation rules to be defined or modified and passed to the test oracle.

A "full" stack typically involves everything from processing and interpretation of low-level sensor data (perception), feeding into primary higher-level functions such as prediction and planning, as well as control logic to generate suitable control signals to implement planning-level decisions (e.g. to control braking, steering, acceleration etc.). For autonomous vehicles, level 3 stacks include some logic to implement transition demands and level 4 stacks additionally include some logic for implementing minimum risk maneuvers. The stack may also implement secondary control functions e.g. of signalling, headlights, windscreen wipers etc.

The term "stack" can also refer to individual sub-systems (sub-stacks) of the full stack, such as perception, prediction, planning or control stacks, which may be tested individually or in any desired combination. A stack can refer purely to software, i.e. one or more computer programs that can be executed on one or more general-purpose computer processors.

Whether real or simulated, a scenario requires an ego agent to navigate a real or modelled physical context. The ego agent is a real or simulated mobile robot that moves under the control of the stack under testing. The physical context includes static and/or dynamic element(s) that the stack under testing is required to respond to effectively. For example, the mobile robot may be a fully or semi-autonomous vehicle under the control of the stack (the ego vehicle). The physical context may comprise a static road layout and a given set of environmental conditions (e.g. weather, time of day, lighting conditions, humidity, pollution/particulate level etc.) that could be maintained or varied as the scenario progresses. An interactive scenario additionally includes one or more other non-ego agents ("external" agent(s), e.g. other vehicles, pedestrians, cyclists, animals etc.).

The following examples consider applications to autonomous vehicle testing. However, the principles apply equally to other forms of mobile robot.

Scenarios may be represented or defined at different levels of abstraction. More abstracted scenarios accommodate a greater degree of variation. For example, a "cut-in scenario" or a "lane change scenario" are examples of highly abstracted scenarios, characterized by a maneuver or behaviour of interest, that accommodate many variations (e.g. different agent starting locations and speeds, road layout, environmental conditions etc.). A "scenario run" refers to a concrete occurrence of an agent(s) navigating a physical context, optionally in the presence of one or more other agents. For example, multiple runs of a cut-in or lane change scenario could be performed (in the real-world and/or in a simulator) with different agent parameters (e.g. starting location, speed etc.), different road layouts, different environmental conditions, and/or different stack configurations etc. The terms "run" and "instance" are used interchangeably in this context.

In the following examples, the performance of the stack is assessed, at least in part, by evaluating the behaviour of the ego agent in the test oracle against a given set of performance evaluation rules, over the course of one or more runs. The rules are applied to "ground truth" of the (or each) scenario run which, in general, simply means an appropriate representation of the scenario run (including the behaviour of the ego agent) that is taken as authoritative for the purpose of testing. Ground truth is inherent to simulation; a simulator computes a sequence of scenario states, which is, by definition, a perfect, authoritative representation of the simulated scenario run. In a real-world scenario run, a "perfect" representation of the scenario run does not exist in the same sense; nevertheless, suitably informative ground truth can be obtained in numerous ways, e.g. based on manual annotation of on-board sensor data, automated/semi-automated annotation of such data (e.g. using offline/non-real time processing), and/or using external information sources (such as external sensors, maps etc.) etc.

The scenario ground truth typically includes a "trace" of the ego agent and any other (salient) agent(s) as applicable. A trace is a history of an agent's location and motion over the course of a scenario. There are many ways a trace can be represented. Trace data will typically include spatial and motion data of an agent within the environment. The term is used in relation to both real scenarios (with real-world traces) and simulated scenarios (with simulated traces). The trace typically records an actual trajectory realized by the agent in the scenario. With regards to terminology, a "trace" and a "trajectory" may contain the same or similar types of information (such as a series of spatial and motion states over time). The term trajectory is generally favoured in the context of planning (and can refer to future/predicted trajectories), whereas the term trace is generally favoured in relation to past behaviour in the context of testing/evaluation.

In a simulation context, a "scenario description" is provided to a simulator as input. For example, a scenario description may be encoded using a scenario description language (SDL), or in any other form that can be consumed by a simulator. A scenario description is typically a more abstract representation of a scenario, that can give rise to multiple simulated runs. Depending on the implementation, a scenario description may have one or more configurable parameters that can be varied to increase the degree of possible variation. The degree of abstraction and parameterization is a design choice. For example, a scenario description may encode a fixed layout, with parameterized environmental conditions (such as weather, lighting etc.). Further abstraction is possible, however, e.g. with configurable road parameter(s) (such as road curvature, lane configuration etc.). The input to the simulator comprises the scenario description together with a chosen set of parameter value(s) (as applicable). The latter may be referred to as a parameterization of the scenario. The configurable parameter(s) define a parameter space (also referred to as the scenario space), and the parameterization corresponds to a point in the parameter space. In this context, a "scenario instance" may refer to an instantiation of a scenario in a simulator based on a scenario description and (if applicable) a chosen parameterization.

For conciseness, the term scenario may also be used to refer to a scenario run, as well a scenario in the more abstracted sense. The meaning of the term scenario will be clear from the context in which it is used.

Trajectory planning is an important function in the present context, and the terms "trajectory planner", "trajectory planning system" and "trajectory planning stack" may be used interchangeably herein to refer to a component or components that can plan trajectories for a mobile robot into the future. Trajectory planning decisions ultimately determine the actual trajectory realized by the ego agent (although, in some testing contexts, this may be influenced by other factors, such as the implementation of those decisions in the control stack, and the real or modelled dynamic response of the ego agent to the resulting control signals).

A trajectory planner may be tested in isolation, or in combination with one or more other systems (e.g. perception, prediction and/or control). Within a full stack, planning generally refers to higher-level autonomous decision-making capability (such as trajectory planning), whilst control generally refers to the lower-level generation of control signals for carrying out those autonomous decisions. However, in the context of performance testing, the term control is also used in the broader sense. For the avoidance of doubt, when a trajectory planner is said to control an ego agent in simulation, that does not necessarily imply that a control system (in the narrower sense) is tested in combination with the trajectory planner.

**Example AV stack:**

To provide relevant context to the described embodiments, further details of an example form of AV stack will now be described.

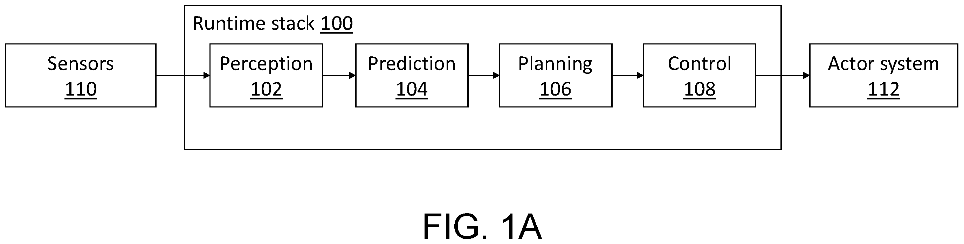

Figure 1A shows a highly schematic block diagram of a runtime stack 100 for an autonomous vehicle (AV), also referred to herein as an ego vehicle (EV). The run time stack 100 is shown to comprise a perception system 102, a prediction system 104, a planner 106 and a controller 108. The terms sub-system, stack and sub-stack may also be used to describe the aforementioned components 102-108.

In a real-world context, the perception system 102 would receive sensor outputs from an on-board sensor system 110 of the AV and uses those sensor outputs to detect external agents and measure their physical state, such as their position, velocity, acceleration etc. The on-board sensor system 110 can take different forms but generally comprises a variety of sensors such as image capture devices (cameras/optical sensors), LiDAR and/or RADAR unit(s), satellite-positioning sensor(s) (GPS etc.), motion sensor(s) (accelerometers, gyroscopes etc.) etc., which collectively provide rich sensor data from which it is possible to extract detailed information about the surrounding environment and the state of the AV and any external actors (vehicles, pedestrians, cyclists etc.) within that environment. The sensor outputs typically comprise sensor data of multiple sensor modalities such as stereo images from one or more stereo optical sensors, LiDAR, RADAR etc. Stereo imaging may be used to collect dense depth data, with LiDAR/RADAR etc. proving potentially more accurate but less dense depth data. More generally, depth data collection from multiple sensor modalities may be combined in a way that preferably respects their respective levels of uncertainty (e.g. using Bayesian or non-Bayesian processing or some other statistical process etc.). Multiple stereo pairs of optical sensors may be located around the vehicle e.g. to provide full 360° depth perception.

The perception system 102 comprises multiple perception components which co-operate to interpret the sensor outputs and thereby provide perception outputs to the prediction system 104. External agents may be detected and represented probabilistically in a way that reflects the level of uncertainty in their perception within the perception system 102.

In a simulation context, depending on the nature of the testing - and depending, in particular, on where the stack 100 is sliced - it may or may not be necessary to model the on-board sensor system 100. With higher-level slicing, simulated sensor data is not required therefore complex sensor modelling is not required.

The perception outputs from the perception system 102 are used by the prediction system 104 to predict future behaviour of external actors (agents), such as other vehicle in the vicinity of the AV.

Predictions computed by the prediction system 104 are provided to the planner 106, which uses the predictions to make autonomous driving decisions to be executed by the AV in a given driving scenario. A scenario is represented as a set of scenario description parameters used by the planner 106. A typical scenario would define a drivable area and would also capture predicted movements of any external agents (obstacles, form the AV's perspective) within the drivable area. The driveable area can be determined using perception outputs from the perception system 102 in combination with map information, such as an HD (high-definition) map.

A core function of the planner 106 is the planning of trajectories for the AV (ego trajectories) taking into account predicted agent motion. This may be referred to as maneuver planning. A trajectory is planned in order to carry out a desired goal within a scenario. The goal could for example be to enter a roundabout and leave it at a desired exit; to overtake a vehicle in front; or to stay in a current lane at a target speed (lane following). The goal may, for example, be determined by an autonomous route planner (not shown).

The controller 108 executes the decisions taken by the planner 106 by providing suitable control signals to an on-board actor system 112 of the AV. In particular, the planner 106 plans trajectories to be taken by the AV and the controller 108 generates control signals in order to execute those trajectories. Typically, the planner 106 will plan into the future, such that a planned trajectory may only be partially implemented at the control level before a new trajectory is planned by the planner 106. The actor system 112 includes "primary" vehicle systems, such as braking, acceleration and steering systems, as well as secondary systems (e.g. signalling, wipers, headlights etc.).

Note, there may be a distinction between a planned trajectory at a given time instant, and the actual trajectory followed by the ego agent. Planning systems typically operate over a sequence of planning steps, updating the planned trajectory at each planning step to account for any changes in the scenario since the previous planning step (or, more precisely, any changes that deviate from the predicted changes). The planning system 106 may reason into the future, such that the planned trajectory at each planning step extends beyond the next planning step. Any individual planned trajectory may, therefore, not be fully realized (if the planning system 106 is tested in isolation, in simulation, the ego agent may simply follow the planned trajectory exactly up to the next planning step; however, as noted, in other real and simulation contexts, the planned trajectory may not be followed exactly up to the next planning step, as the behaviour of the ego agent could be influenced by other factors, such as the operation of the control system 108 and the real or modelled dynamics of the ego vehicle). In many testing contexts, the actual trajectory of the ego agent is what ultimately matters; in particular, whether the actual trajectory is safe, as well as other factors such as comfort and progress. However, the rules-based testing approach herein can also be applied to planned trajectories (even if those planned trajectories are not fully or exactly realized by the ego agent). For example, even if the actual trajectory of an agent is deemed safe according to a given set of safety rules, it might be that an instantaneous planned trajectory was unsafe; the fact that the planner 106 was considering an unsafe course of action may be revealing, even if it did not lead to unsafe agent behaviour in the scenario. Instantaneous planned trajectories constitute one form of internal state that can be usefully evaluated, in addition to actual agent behaviour in the simulation. Other forms of internal stack state can be similarly evaluated.

The example of Figure 1A considers a relatively "modular" architecture, with separable perception, prediction, planning and control systems 102-108. The sub-stack themselves may also be modular, e.g. with separable planning modules within the planning system 106. For example, the planning system 106 may comprise multiple trajectory planning modules that can be applied in different physical contexts (e.g. simple lane driving vs. complex junctions or roundabouts). This is relevant to simulation testing for the reasons noted above, as it allows components (such as the planning system 106 or individual planning modules thereof) to be tested individually or in different combinations. For the avoidance of doubt, with modular stack architectures, the term stack can refer not only to the full stack but to any individual sub-system or module thereof.

The extent to which the various stack functions are integrated or separable can vary significantly between different stack implementations - in some stacks, certain aspects may be so tightly coupled as to be indistinguishable. For example, in other stacks, planning and control may be integrated (e.g. such stacks could plan in terms of control signals directly), whereas other stacks (such as that depicted in Figure 1A) may be architected in a way that draws a clear distinction between the two (e.g. with planning in terms of trajectories, and with separate control optimizations to determine how best to execute a planned trajectory at the control signal level). Similarly, in some stacks, prediction and planning may be more tightly coupled. At the extreme, in so-called "end-to-end" driving, perception, prediction, planning and control may be essentially inseparable. Unless otherwise indicated, the perception, prediction planning and control terminology used herein does not imply any particular coupling or modularity of those aspects.

It will be appreciated that the term "stack" encompasses software, but can also encompass hardware. In simulation, software of the stack may be tested on a "generic" off-board computer system, before it is eventually uploaded to an on-board computer system of a physical vehicle. However, in "hardware-in-the-loop" testing, the testing may extend to underlying hardware of the vehicle itself. For example, the stack software may be run on the on-board computer system (or a replica thereof) that is coupled to the simulator for the purpose of testing. In this context, the stack under testing extends to the underlying computer hardware of the vehicle. As another example, certain functions of the stack 110 (e.g. perception functions) may be implemented in dedicated hardware. In a simulation context, hardware-in-the loop testing could involve feeding synthetic sensor data to dedicated hardware perception components.

**Example testing paradigm:**

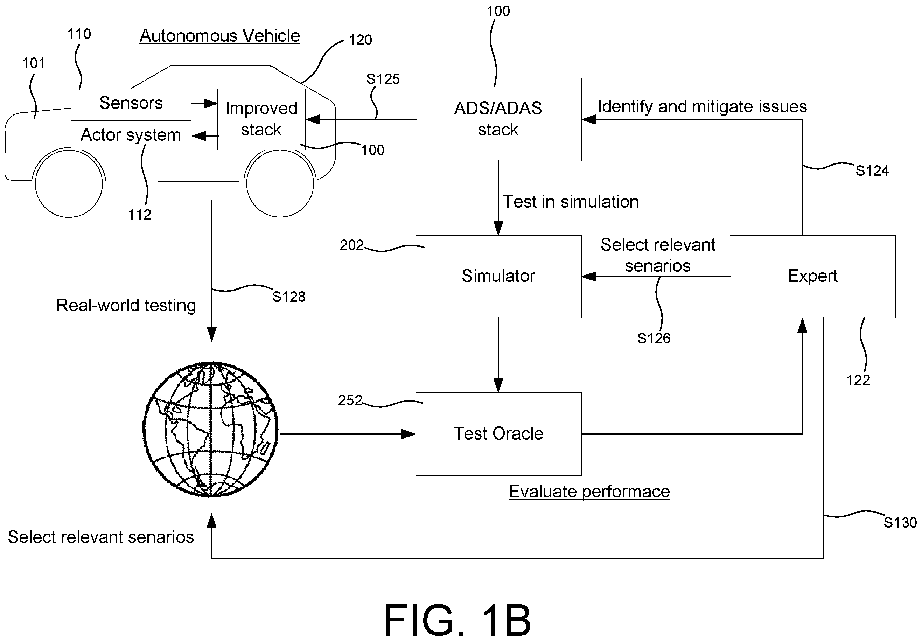

Figure 1B shows a highly schematic overview of a testing paradigm for autonomous vehicles. An ADS/ADAS stack 100, e.g. of the kind depicted in Figure 1A, is subject to repeated testing and evaluation in simulation, by running multiple scenario instances in a simulator 202, and evaluating the performance of the stack 100 (and/or individual subs-stacks thereof) in a test oracle 252. The output of the test oracle 252 is informative to an expert 122 (team or individual), allowing them to identify issues in the stack 100 and modify the stack 100 to mitigate those issues (S124). The results also assist the expert 122 in selecting further scenarios for testing (S126), and the process continues, repeatedly modifying, testing and evaluating the performance of the stack 100 in simulation. The improved stack 100 is eventually incorporated (S125) in a real-world AV 101, equipped with a sensor system 110 and an actor system 112. The improved stack 100 typically includes program instructions (software) executed in one or more computer processors of an on-board computer system of the vehicle 101 (not shown). The software of the improved stack is uploaded to the AV 101 at step S125. Step S125 may also involve modifications to the underlying vehicle hardware. On board the AV 101, the improved stack 100 receives sensor data from the sensor system 110 and outputs control signals to the actor system 112. Real-world testing (S128) can be used in combination with simulation-based testing. For example, having reached an acceptable level of performance though the process of simulation testing and stack refinement, appropriate real-world scenarios may be selected (S130), and the performance of the AV 101 in those real scenarios may be captured and similarly evaluated in the test oracle 252.

Scenarios can be obtained for the purpose of simulation in various ways, including manual encoding. The system is also capable of extracting scenarios for the purpose of simulation from real-world runs, allowing real-world situations and variations thereof to be re-created in the simulator 202.

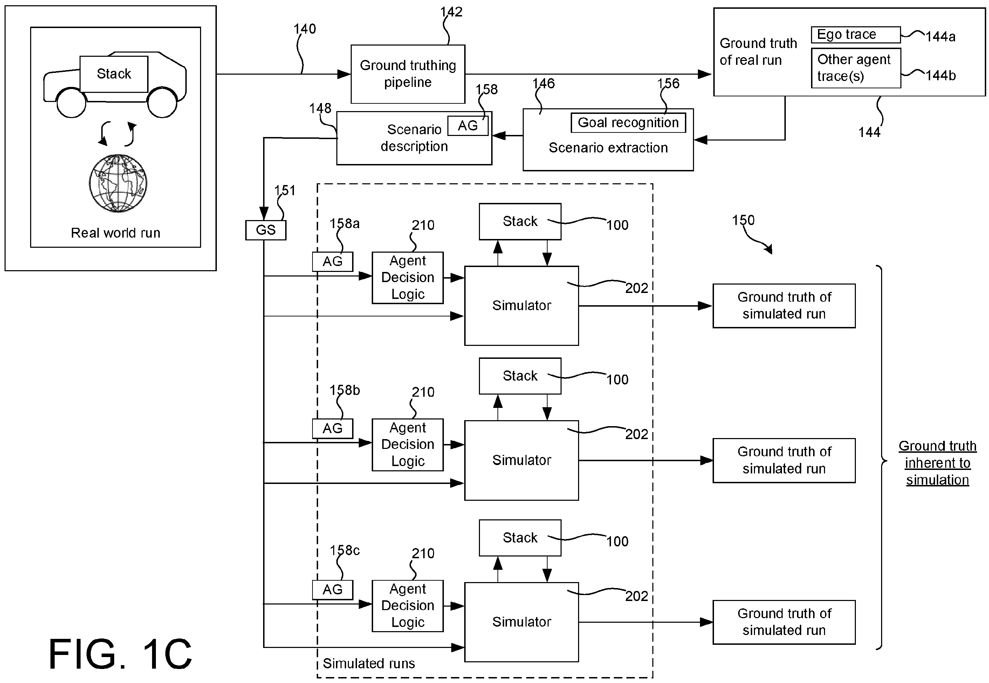

Figure 1C shows a highly schematic block diagram of a scenario extraction pipeline. Data 140 of a real-world run is passed to a 'ground-truthing' pipeline 142 (trace extraction component) for the purpose of generating scenario ground truth. The run data 140 could comprise, for example, sensor data and/or perception outputs captured/generated on board one or more vehicles (which could be autonomous, human-driven or a combination thereof), and/or data captured from other sources such external sensors (CCTV etc.). The run data is processed within the ground truthing pipeline 142, in order to generate appropriate ground truth 144 (trace(s) and contextual data) for the real-world run. The ground truth of the real-world run 144 comprises an extracted ego trace of the ego agent and one or more extracted agent trace(s) of one or more other (non-ego) agents. As discussed, the ground-truthing process could be based on manual annotation of the 'raw' run data 142, or the process could be entirely automated (e.g. using offline perception method(s)), or a combination of manual and automated ground truthing could be used. For example, 3D bounding boxes may be placed around vehicles and/or other agents captured in the run data 140, in order to determine spatial and motion states of their traces. A scenario extraction component 146 receives the scenario ground truth 144, and processes the scenario ground truth 144 to extract a more abstracted scenario description 148 that can be used for the purpose of simulation. The scenario description 148 is consumed by the simulator 202, allowing multiple simulated runs to be performed. The simulated runs are variations of the original real-world run, with the degree of possible variation determined by the extent of abstraction. Ground truth 150 is provided for each simulated run.

In the present off-board content, there is no requirement for the traces to be extracted in real-time (or, more precisely, no need for them to be extracted in a manner that would support real-time planning); rather, the traces are extracted "offline". Examples of offline perception algorithms include non-real time and non-causal perception algorithms. Offline techniques contrast with "on-line" techniques that can feasibly be implemented within an AV stack 100 to facilitate real-time planning/decision making.

For example, it is possible to use non-real time processing, which cannot be performed on-line due to hardware or other practical constraints of an AV's onboard computer system. For example, one or more non-real time perception algorithms can be applied to the real-world run data 140 to extract the traces. A non-real time perception algorithm could be an algorithm that it would not be feasible to run in real time because of the computation or memory resources it requires.

It is also possible to use "non-causal" perception algorithms in this context. A non-causal algorithm may or may not be capable of running in real-time at the point of execution, but in any event could not be implemented in an online context, because it requires knowledge of the future. For example, a perception algorithm that detects an agent state (e.g. location, pose, speed etc.) at a particular time instant based on subsequent data could not support real-time planning within the stack 100 in an on-line context, because it requires knowledge of the future (unless it was constrained to operate with a short look ahead window). For example, filtering with a backwards pass is a non-causal algorithm that can sometimes be run in real-time, but requires knowledge of the future.

The term "perception" generally refers to techniques for perceiving structure in the real-world data 140, such as 2D or 3D bounding box detection, location detection, pose detection, motion detection etc. For example, a trace may be extracted as a time-series of bounding boxes or other spatial states in 3D space or 2D space (e.g. in a birds-eye-view frame of reference), with associated motion information (e.g. speed, acceleration, jerk etc.).

**Closed-loop scenario extraction:**

Referring still to Figure 1C, the scenario description 148 is "closed loop" in the sense that is contains sufficient information about one or more non-ego agent(s) in the run to enable the behaviour of those non-agent agent(s) to be simulated in a closed-loop manner. Such agents may be referred to as autonomous non-ego agents. To this end, some form agent decision logic 210 is coupled to the simulator 202. The agent decision logic 210 has some degree of autonomous decision-making functionality that is applied to any autonomous non-ego agent in the scenario.

The scenario description 148 is shown to comprise agent goal data 158 that is extracted from the scenario ground truth of the real-world run 144 by a goal recognition component 156 of the scenario extraction component 146. The agent goal data 158 encodes one or more goals that have been (probabilistically or deterministically) inferred from the non-ego trace(s) 144b. The agent goal data 158 facilitates reactive, closed-loop behaviour for non-ego agent(s). In this context, closed-loop refers to the fact that, in simulation, the trajectory of each autonomous non-ego agent is planned autonomously, by the agent decision logic 210, towards a defined goal, with the agent capable of reacting to the behaviour of the ego agent (and possibly other non-ego agent(s) as well). The ego agent is controlled by the stack 100 under testing, in order to evaluate the performance of the stack 100. Closed-loop simulation has the potential to increase the realism of the simulation, increasing the extent to which results obtained in simulation are applicable to the real-world.

Goals may be inferred probabilistically by the goal recognition component 156. For example, a distribution over different possible goals may be computed by the goal recognition component 156, where different probabilities may be attached to the different goals. To this end, a goal sampling component 150 is provided that samples a goal for each autonomous non-ego agent from a goal distribution inferred for that agent. Reference numerals 158a, 158b and 158c each denote one or more agent goals that have been sampled from one or more agent goal distributions that are encoded in the agent goal data 158, for the purpose of different simulated runs.

The present techniques can also be applied with deterministic goal recognition, in which case the goal sampling component 151 may be omitted, and deterministic goals may be inferred and provided directly to the agent decision logic 210.

Whilst the example of Figure 1C considers goal inference, the same techniques can, alternatively or additionally, be applied to infer and implement maneuvers or other behaviours in a closed-loop fashion. Maneuvers may be inferred deterministically, or probabilistically with maneuvers sampled in a similar manner to goals. A goal generally refers to a relatively longer-term objective (e.g. which might remain fixed over the course of a simulated run), whilst a maneuver generally occurs over a relatively shorter time scale. Goal and maneuver recognition can be used together or in combination. For example, a simulated run might commence with each autonomous non-ego agent implementing some deterministic or sampled maneuver, and planning into the future towards some defined goal in a manner that allows subsequent maneuvers to be planned for the autonomous non-ego agent(s) in a closed-loop manner (such that different subsequent maneuvers may be selected in different simulations, e.g. as a consequence of an autonomous non-ego agent reacting to the behaviour of the ego agent).

The agent decision logic 210 can take the form of a second autonomous driving system/stack, which could be similar in complexity to the stack 100 under testing (first stack) or a simpler form of autonomous system. Preferably, the agent decision logic 210 is configured so that, to the extent the behaviour of the ego agent matches the behaviour of the corresponding real ego agent in the real-world run, the behaviour of the non-ego agent also matches the behaviour of the corresponding non-ego agent in the real world data (at least approximately). That is, the agent decision logic 210 is tuned to give results similar to the observed results when there is no disturbance from alternative ego behaviour. This implies that, to the extent the trajectory realised by the ego agent in simulation matches the trace of the real-world ego agent, the trajectory realized by the non-ego agent (under the control of the agent decision logic 210) also matches the observed trace of the real-world non-ego agent.

Reference is made to International Patent Publication Nos. WO2020/079066 and WO2021/073781. The aforementioned references disclose a class of "inverse planning" methods that can be applied to goal and behaviour (e.g. maneuver) recognition. Those references apply inverse planning for the purpose of prediction and planning within an ego stack: in that context, once a goal or behaviour has been inferred, it can be used to predict an agent trajectory, which in turn can be used as a basis for ego planning. The present disclosure considers a novel application of those techniques, to identify a goal/behaviour of a non-ego agent to facilitate closed-loop simulation in an offline/off-board testing/simulation context.

Once a goal or behaviour has been inferred, the aim is to re-create observed behaviour in a simulator, but in a closed-loop (reactive manner). That is, the goal/behaviour recognition method of the above references can be applied for the purpose of associating a goal or behaviour with an agent to be simulated.

In the examples below, the goal recognition component 151 infers goals by applying an inverse planning method to the non-ego trace(s) 144b. The application of inverse planning in the present context is described in further detail below. First, further details of the testing pipeline are described.

**Testing pipeline:**

Further details of the testing pipeline and the test oracle 252 will now be described. The examples that follow focus on simulation-based testing. However, as noted, the test oracle 252 can equally be applied to evaluate stack performance on real scenarios, and the relevant description below applies equally to real scenarios. The following description refers to the stack 100 of Figure 1A by way of example. However, as noted, the testing pipeline 200 is highly flexible and can be applied to any stack or sub-stack operating at any level of autonomy.

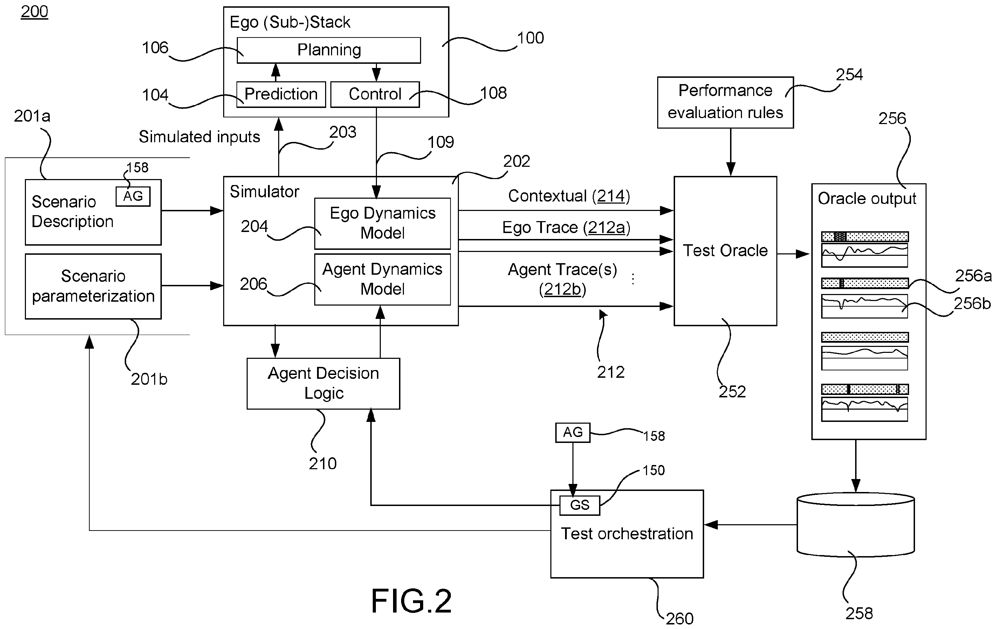

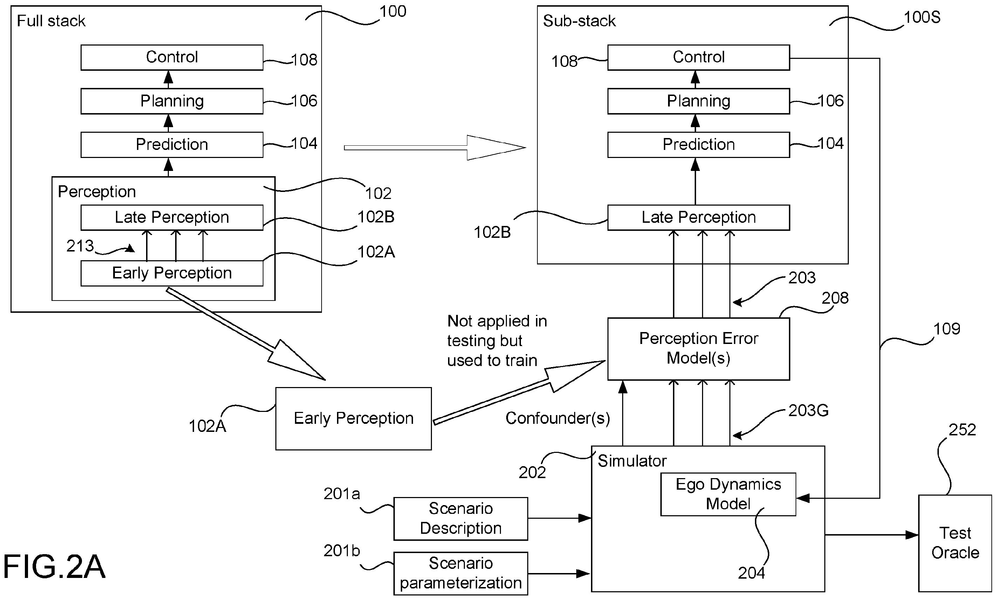

Figure 2 shows a schematic block diagram of the testing pipeline, denoted by reference numeral 200. The testing pipeline 200 is shown to comprise the simulator 202 and the test oracle 252. The simulator 202 runs simulated scenarios for the purpose of testing all or part of an AV run time stack 100, and the test oracle 252 evaluates the performance of the stack (or sub-stack) on the simulated scenarios. As discussed, it may be that only a sub-stack of the run-time stack is tested, but for simplicity, the following description refers to the (full) AV stack 100 throughout. However, the description applies equally to a sub-stack in place of the full stack 100. The term "slicing" is used herein to the selection of a set or subset of stack components for testing.

As described previously, the idea of simulation-based testing is to run a simulated driving scenario that an ego agent must navigate under the control of the stack 100 being tested. Typically, the scenario includes a static drivable area (e.g. a particular static road layout) that the ego agent is required to navigate, typically in the presence of one or more other dynamic agents (such as other vehicles, bicycles, pedestrians etc.). To this end, simulated inputs 203 are provided from the simulator 202 to the stack 100 under testing.

The slicing of the stack dictates the form of the simulated inputs 203. By way of example, Figure 2 shows the prediction, planning and control systems 104, 106 and 108 within the AV stack 100 being tested. To test the full AV stack of Figure 1A, the perception system 102 could also be applied during testing. In this case, the simulated inputs 203 would comprise synthetic sensor data that is generated using appropriate sensor model(s) and processed within the perception system 102 in the same way as real sensor data. This requires the generation of sufficiently realistic synthetic sensor inputs (such as photorealistic image data and/or equally realistic simulated lidar/radar data etc.). The resulting outputs of the perception system 102 would, in turn, feed into the higher-level prediction and planning systems 104, 106.

By contrast, so-called "planning-level" simulation would essentially bypass the perception system 102. The simulator 202 would instead provide simpler, higher-level inputs 203 directly to the prediction system 104. In some contexts, it may even be appropriate to bypass the prediction system 104 as well, in order to test the planner 106 on predictions obtained directly from the simulated scenario (i.e. "perfect" predictions).

Between these extremes, there is scope for many different levels of input slicing, e.g. testing only a subset of the perception system 102, such as "later" (higher-level) perception components, e.g. components such as filters or fusion components which operate on the outputs from lower-level perception components (such as object detectors, bounding box detectors, motion detectors etc.).

Whatever form they take, the simulated inputs 203 are used (directly or indirectly) as a basis for decision-making by the planner 108. The controller 108, in turn, implements the planner's decisions by outputting control signals 109. In a real-world context, these control signals would drive the physical actor system 112 of AV. In simulation, an ego vehicle dynamics model 204 is used to translate the resulting control signals 109 into realistic motion of the ego agent within the simulation, thereby simulating the physical response of an autonomous vehicle to the control signals 109.

Alternatively, a simpler form of simulation assumes that the ego agent follows each planned trajectory exactly between planning steps. This approach bypasses the control system 108 (to the extent it is separable from planning) and removes the need for the ego vehicle dynamic model 204. This may be sufficient for testing certain facets of planning.

To the extent that external agents exhibit autonomous behaviour/decision making within the simulator 202, some form of agent decision logic 210 is implemented to carry out those decisions and determine agent behaviour within the scenario. The agent decision logic 210 may be comparable in complexity to the ego stack 100 itself or it may have a more limited decision-making capability. The aim is to provide sufficiently realistic external agent behaviour within the simulator 202 to be able to usefully test the decision-making capabilities of the ego stack 100. In some contexts, this does not require any agent decision making logic 210 at all (open-loop simulation), and in other contexts useful testing can be provided using relatively limited agent logic 210 such as basic adaptive cruise control (ACC). One or more agent dynamics models 206 may be used to provide more realistic agent behaviour if appropriate. Given a goal, the agent decision logic 210 has the ability to plan a trajectory for a non-ego agent with the objective of fulfilling that goal, taking into account behaviour of the ego agent (and possibly other agent(s) as well).

A scenario is run in accordance with a scenario description 201a and (if applicable) a chosen parameterization 201b of the scenario. A scenario typically has both static and dynamic elements which may be "hard coded" in the scenario description 201a or configurable and thus determined by the scenario description 201a in combination with a chosen parameterization 201b. In a driving scenario, the static element(s) typically include a static road layout.

The dynamic element(s) typically include one or more external agents within the scenario, such as other vehicles, pedestrians, bicycles etc.

The extent of the dynamic information provided to the simulator 202 for each external agent can vary. For example, a scenario may be described by separable static and dynamic layers. A given static layer (e.g. defining a road layout) can be used in combination with different dynamic layers to provide different scenario instances. The dynamic layer may comprise, for each external agent, a spatial path to be followed by the agent together with one or both of motion data and behaviour data associated with the path. In simple open-loop simulation, an external actor simply follows the spatial path and motion data defined in the dynamic layer that is non-reactive i.e. does not react to the ego agent within the simulation. Such open-loop simulation can be implemented without any agent decision logic 210. However, in closed-loop simulation, the dynamic layer instead defines at least one behaviour to be followed along a static path (such as an ACC behaviour). In this case, the agent decision logic 210 implements that behaviour within the simulation in a reactive manner, i.e. reactive to the ego agent and/or other external agent(s). Motion data may still be associated with the static path but in this case is less prescriptive and may for example serve as a target along the path. For example, with an ACC behaviour, target speeds may be set along the path which the agent will seek to match, but the agent decision logic 210 might be permitted to reduce the speed of the external agent below the target at any point along the path in order to maintain a target headway from a forward vehicle.

As will be appreciated, scenarios can be described for the purpose of simulation in many ways, with any degree of configurability. For example, the number and type of agents, and their motion information may be configurable as part of the scenario parameterization 201b.

The output of the simulator 202 for a given simulation includes an ego trace 212a of the ego agent and one or more agent traces 212b of the one or more external agents (traces 212). Each trace 212a, 212b is a complete history of an agent's behaviour within a simulation having both spatial and motion components. For example, each trace 212a, 212b may take the form of a spatial path having motion data associated with points along the path such as speed, acceleration, jerk (rate of change of acceleration), snap (rate of change of jerk) etc.

Additional information is also provided to supplement and provide context to the traces 212. Such additional information is referred to as "contextual" data 214. The contextual data 214 pertains to the physical context of the scenario, and can have both static components (such as road layout) and dynamic components (such as weather conditions to the extent they vary over the course of the simulation). To an extent, the contextual data 214 may be "passthrough" in that it is directly defined by the scenario description 201a or the choice of parameterization 201b, and is thus unaffected by the outcome of the simulation. For example, the contextual data 214 may include a static road layout that comes from the scenario description 201a or the parameterization 201b directly. However, typically the contextual data 214 would include at least some elements derived within the simulator 202. This could, for example, include simulated environmental data, such as weather data, where the simulator 202 is free to change weather conditions as the simulation progresses. In that case, the weather data may be time-dependent, and that time dependency will be reflected in the contextual data 214.

The test oracle 252 receives the traces 212 and the environmental/contextual data 214, and scores those outputs against a set of predefined numerical performance metrics to 254. The metrics 254 are numerical in the following examples. The performance evaluation rules 254 are shown to be provided as an input to the test oracle 252. The performance metrics 254 encode what may be referred to herein as a "Digital Highway Code" (DHC). Some examples of suitable performance metrics are given below.

The scoring is time-based: for each performance metric, the test oracle 252 tracks how the value of that metric (the score) changes over time as the simulation progresses. The test oracle 252 provides an output 256 comprising a score-time plot for each performance metric.

The metrics 256 are informative to an expert and the scores can be used to identify and mitigate performance issues within the tested stack 100.

Herein, a performance evaluation rule may refer to a numerical or a categorical metric. Certain categorical rules are also associated with numerical performance metrics used to "score" trajectories (e.g. indicating a degree of success or failure or some other quantity that helps explain or is otherwise relevant to the categorical results). For example, a numerical score may be computed, and mapped to a categorical (e.g. pass/fail) result based on a failure threshold or other predefined rule logic. In the following description, a "rule" generally refers to the combination of a numerical metric and some additional logic to obtain categorical (e.g. pass/fail) results therefrom.

The evaluation of the rules 254 is time-based - a given rule may have a different outcome at different points in the scenario. The scoring is also time-based: for each performance evaluation metric, the test oracle 252 tracks how the value of that metric (the score) changes over time as the simulation progresses. The test oracle 252 provides an output 256 comprising a time sequence 256a of categorical (e.g. pass/fail) results for each rule, and a score-time plot 256b for each performance metric, as described in further detail later. The results and scores 256a, 256b are informative to the expert 122 and can be used to identify and mitigate performance issues within the tested stack 100. The test oracle 252 also provides an overall (aggregate) result for the scenario (e.g. overall pass/fail). The output 256 of the test oracle 252 is stored in a test database 258, in association with information about the scenario to which the output 256 pertains. For example, the output 256 may be stored in association with the scenario description 210a (or an identifier thereof), and the chosen parameterization 201b. As well as the time-dependent results and scores, an overall score may also be assigned to the scenario and stored as part of the output 256. For example, an aggregate score for each rule (e.g. overall pass/fail) and/or an aggregate result (e.g. pass/fail) across all of the rules 254.

Figure 2A illustrates another choice of slicing and uses reference numerals 100 and 100S to denote a full stack and sub-stack respectively. It is the sub-stack 100S that would be subject to testing within the testing pipeline 200 of Figure 2.

A number of "later" perception components 102B form part of the sub-stack 100S to be tested and are applied, during testing, to simulated perception inputs 203. The later perception components 102B could, for example, include filtering or other fusion components that fuse perception inputs from multiple earlier perception components.

In the full stack 100, the later perception components 102B would receive actual perception inputs 213 from earlier perception components 102A. For example, the earlier perception components 102A might comprise one or more 2D or 3D bounding box detectors, in which case the simulated perception inputs provided to the late perception components could include simulated 2D or 3D bounding box detections, derived in the simulation via ray tracing. The earlier perception components 102A would generally include component(s) that operate directly on sensor data. With the slicing of Figure 2A, the simulated perception inputs 203 would correspond in form to the actual perception inputs 213 that would normally be provided by the earlier perception components 102A. However, the earlier perception components 102A are not applied as part of the testing, but are instead used to train one or more perception error models 208 that can be used to introduce realistic error, in a statistically rigorous manner, into the simulated perception inputs 203 that are fed to the later perception components 102B of the sub-stack 100 under testing.

Such perception error models may be referred to as Perception Statistical Performance Models (PSPMs) or, synonymously, "PRISMs". Further details of the principles of PSPMs, and suitable techniques for building and training them, may be bound in International Patent Publication Nos. WO2021037763 WO2021037760, WO2021037765, WO2021037761, and WO2021037766. The idea behind PSPMs is to efficiently introduce realistic errors into the simulated perception inputs provided to the sub-stack 100S (i.e. that reflect the kind of errors that would be expected were the earlier perception components 102A to be applied in the real-world). In a simulation context, "perfect" ground truth perception inputs 203G are provided by the simulator, but these are used to derive more realistic perception inputs 203 with realistic error introduced by the perception error models(s) 208.

As described in the aforementioned reference, a PSPM can be dependent on one or more variables representing physical condition(s) ("confounders"), allowing different levels of error to be introduced that reflect different possible real-world conditions. Hence, the simulator 202 can simulate different physical conditions (e.g. different weather conditions) by simply changing the value of a weather confounder(s), which will, in turn, change how perception error is introduced.

The later perception components 102b within the sub-stack 100S process the simulated perception inputs 203 in exactly the same way as they would process the real-world perception inputs 213 within the full stack 100, and their outputs, in turn, drive prediction, planning and control.

Alternatively, PRISMs can be used to model the entire perception system 102, including the late perception components 208, in which case a PSPM(s) is used to generate realistic perception output that are passed as inputs to the prediction system 104 directly.

Depending on the implementation, there may or may not be deterministic relationship between a given scenario parameterization 201b and the outcome of the simulation for a given configuration of the stack 100 (i.e. the same parameterization may or may not always lead to the same outcome for the same stack 100). Non-determinism can arise in various ways. For example, when simulation is based on PRISMs, a PRISM might model a distribution over possible perception outputs at each given time step of the scenario, from which a realistic perception output is sampled probabilistically. This leads to non-deterministic behaviour within the simulator 202, whereby different outcomes may be obtained for the same stack 100 and scenario parameterization because different perception outputs are sampled. Alternatively, or additionally, the simulator 202 may be inherently non-deterministic, e.g. weather, lighting or other environmental conditions may be randomized/probabilistic within the simulator 202 to a degree. As will be appreciated, this is a design choice: in other implementations, varying environmental conditions could instead be fully specified in the parameterization 201b of the scenario. With non-deterministic simulation, multiple scenario instances could be run for each parameterization. An aggregate pass/fail result could be assigned to a particular choice of parameterization 201b, e.g. as a count or percentage of pass or failure outcomes.

A test orchestration component 260 is responsible for selecting scenarios for the purpose of simulation. For example, the test orchestration component 260 may select scenario descriptions 201a and suitable parameterizations 201b automatically, based on the test oracle outputs 256 from previous scenarios.

The test orchestration component 260 is shown to comprise the goal sapling component 151 if Figure 1C for sampling non-ego agent goal(s) from agent goal data 158 included in the scenario description 201 for use by the agent decision logic 210, as described above with reference to Figure 1C.

**Test oracle rules:**

The performance metrics 254 can be based on various factors, such as distance speed etc. In the described system, these can mirror a set of applicable road rules, such as the Highway Code applicable to road users in the United Kingdom. The term "Digital Highway Code" (DHC) may be used in relation to the set of performance metrics 254, however, this is merely a convenient shorthand and does not imply any particular jurisdiction. The DHC can be made up of any set of performance metrics 254 that can assess driving performance numerically. As noted, each metric is numerical and time-dependent. The value of a given metric at a partial time is referred to as a score against that metric at that time.

Relatively simple metric include those based on vehicle speed or acceleration, jerk etc., distance to another agent (e.g. distance to closest cyclist, distance to closest oncoming vehicle, distance to curb, distance to center line etc.). A comfort metric could score the path in terms of acceleration or a first or higher order time derivative of acceleration (jerk, snap etc.). Another form of metric measures progress to a defined goal, such as reaching a particular roundabout exit. A simple progress metric could simply consider time taken to reach a goal. More sophisticated metrics progress metric quantify concepts such as "missed opportunities", e.g. in a roundabout context, the extent to which an ego vehicle is missing opportunities to join a roundabout.

For each metric, an associated "failure threshold" is defined. An ego agent is said to have failed that metric if its score against that metric drops below that threshold.

Not all of the metrics 254 will necessarily apply to a given scenario. For example, a subset of the metrics 254 may be selected that are applicable to a given scenario. An applicable subset of metrics can be selected by the test oracle 254 in dependence on one or both of the environmental data 214 pertaining to the scenario being considered, and the scenario description 201 used to simulate the scenario. For example, certain metric may only be applicable to roundabouts or junctions etc., or to certain weather or lighting conditions.

One or both of the metrics 254 and their associated failure thresholds may be adapted to a given scenario. For example, speed-based metrics and/or their associated performance functions may be adapted in dependence on an applicable speed limit but also weather/lighting conditions etc.

The performance evaluation rules 254 are constructed as computational graphs (rule trees) to be applied within the test oracle. Unless otherwise indicated, the term "rule tree" herein refers to the computational graph that is configured to implement a given rule. Each rule is constructed as a rule tree, and a set of multiple rules may be referred to as a "forest" of multiple rule trees.

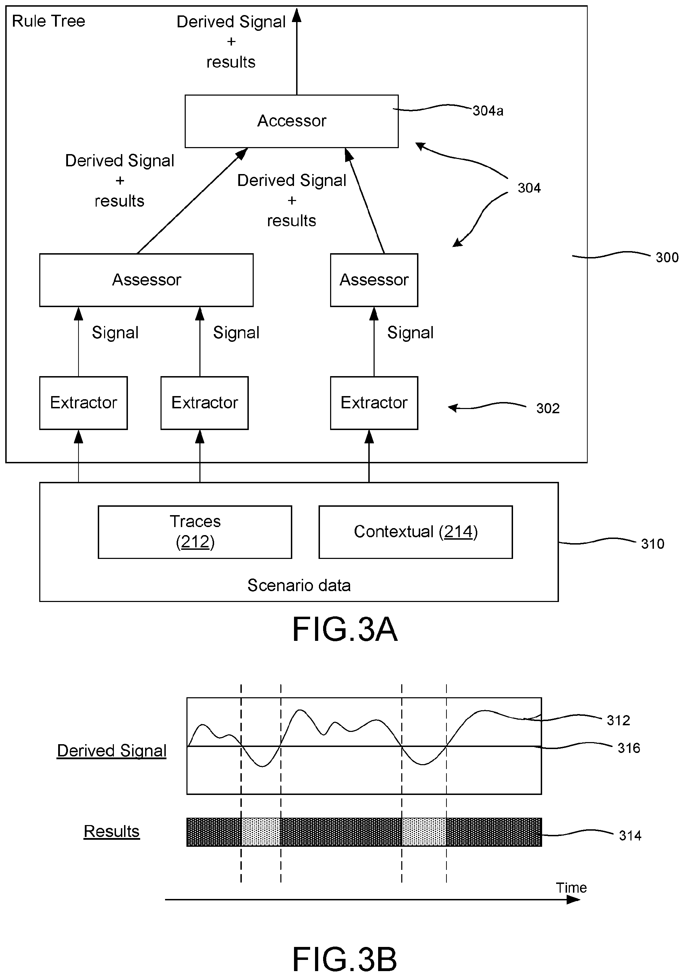

Figure 3A shows an example of a rule tree 300 constructed from a combination of extractor nodes (leaf objects) 302 and assessor nodes (non-leaf objects) 304. Each extractor node 302 extracts a time-varying numerical (e.g. floating point) signal (score) from a set of scenario data 310. The scenario data 310 is a form of scenario ground truth, in the sense laid out above, and may be referred to as such. The scenario data 310 has been obtained by deploying a trajectory planner (such as the planner 106 of Figure 1A) in a real or simulated scenario, and is shown to comprise ego and agent traces 212 as well as contextual data 214. In the simulation context of Figure 2 or Figure 2A, the scenario ground truth 310 is provided as an output of the simulator 202.

Each assessor node 304 is shown to have at least one child object (node), where each child object is one of the extractor nodes 302 or another one of the assessor nodes 304. Each assessor node receives output(s) from its child node(s) and applies an assessor function to those output(s). The output of the assessor function is a time-series of categorical results. The following examples consider simple binary pass/fail results, but the techniques can be readily extended to non-binary results. Each assessor function assesses the output(s) of its child node(s) against a predetermined atomic rule. Such rules can be flexibly combined in accordance with a desired safety model.

In addition, each assessor node 304 derives a time-varying numerical signal from the output(s) of its child node(s), which is related to the categorical results by a threshold condition (see below).

A top-level root node 304a is an assessor node that is not a child node of any other node. The top-level node 304a outputs a final sequence of results, and its descendants (i.e. nodes that are direct or indirect children of the top-level node 304a) provide the underlying signals and intermediate results.

Figure 3B visually depicts an example of a derived signal 312 and a corresponding time-series of results 314 computed by an assessor node 304. The results 314 are correlated with the derived signal 312, in that a pass result is returned when (and only when) the derived signal exceeds a failure threshold 316. As will be appreciated, this is merely one example of a threshold condition that relates a time-sequence of results to a corresponding signal.

Signals extracted directly from the scenario ground truth 310 by the extractor nodes 302 may be referred to as "raw" signals, to distinguish from "derived" signals computed by assessor nodes 304. Results and raw/derived signals may be discretized in time.

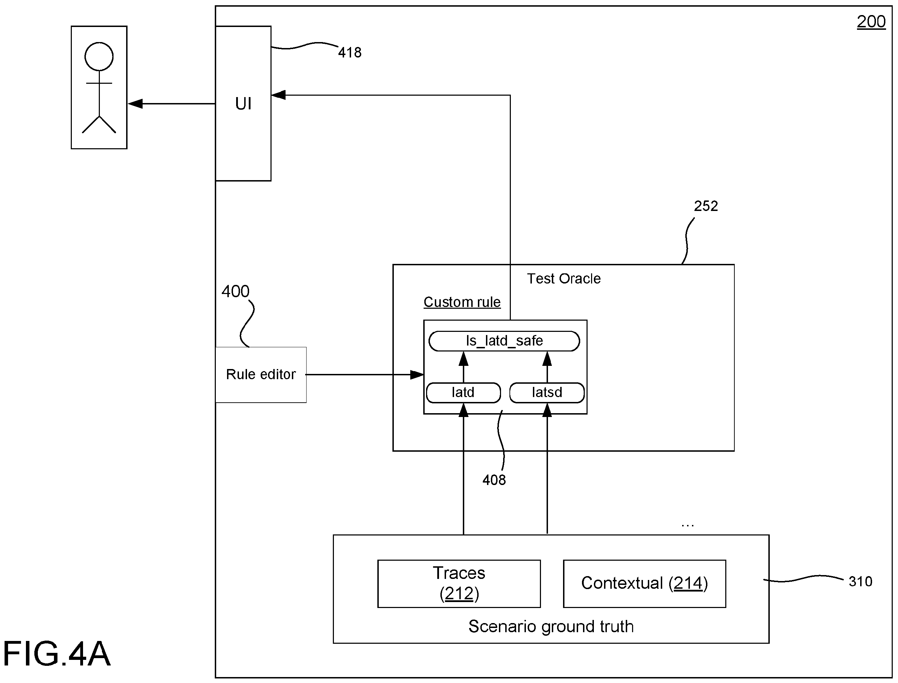

Figure 4A shows an example of a rule tree implemented within the testing platform 200.

A rule editor 400 is provided for constructing rules to be implemented with the test oracle 252. The rule editor 400 receives rule creation inputs from a user (who may or may not be the end-user of the system). In the present example, the rule creation inputs are coded in a domain specific language (DSL) and define at least one rule graph 408 to be implemented within the test oracle 252. The rules are logical rules in the following examples, with TRUE and FALSE representing pass and failure respectively (as will be appreciated, this is purely a design choice).

The following examples consider rules that are formulated using combinations of atomic logic predicates. Examples of basic atomic predicates include elementary logic gates (OR, AND etc.), and logical functions such as "greater than", (Gt(a,b)) (which returns TRUE when a is greater than b, and false otherwise).

A Gt function is to implement a safe lateral distance rule between an ego agent and another agent in the scenario (having agent identifier "other_agent_id"). Two extractor nodes (latd, latsd) apply LateralDistance and LateralSafeDistance extractor functions respectively. Those functions operate directly on the scenario ground truth 310 to extract, respectively, a time-varying lateral distance signal (measuring a lateral distance between the ego agent and the identified other agent), and a time-varying safe lateral distance signal for the ego agent and the identified other agent. The safe lateral distance signal could depend on various factors, such as the speed of the ego agent and the speed of the other agent (captured in the traces 212), and environmental conditions (e.g. weather, lighting, road type etc.) captured in the contextual data 214.

An assessor node (is_latd_safe) is a parent to the latd and latsd extractor nodes, and is mapped to the Gt atomic predicate. Accordingly, when the rule tree 408 is implemented, the is_latd_safe assessor node applies the Gt function to the outputs of the latd and latsd extractor nodes, in order to compute a true/false result for each timestep of the scenario, returning TRUE for each time step at which the latd signal exceeds the latsd signal and FALSE otherwise. In this manner, a "safe lateral distance" rule has been constructed from atomic extractor functions and predicates; the ego agent fails the safe lateral distance rule when the lateral distance reaches or falls below the safe lateral distance threshold. As will be appreciated, this is a very simple example of a rule tree. Rules of arbitrary complexity can be constructed according to the same principles.

The test oracle 252 applies the rule tree 408 to the scenario ground truth 310, and provides the results via a user interface (UI) 418.

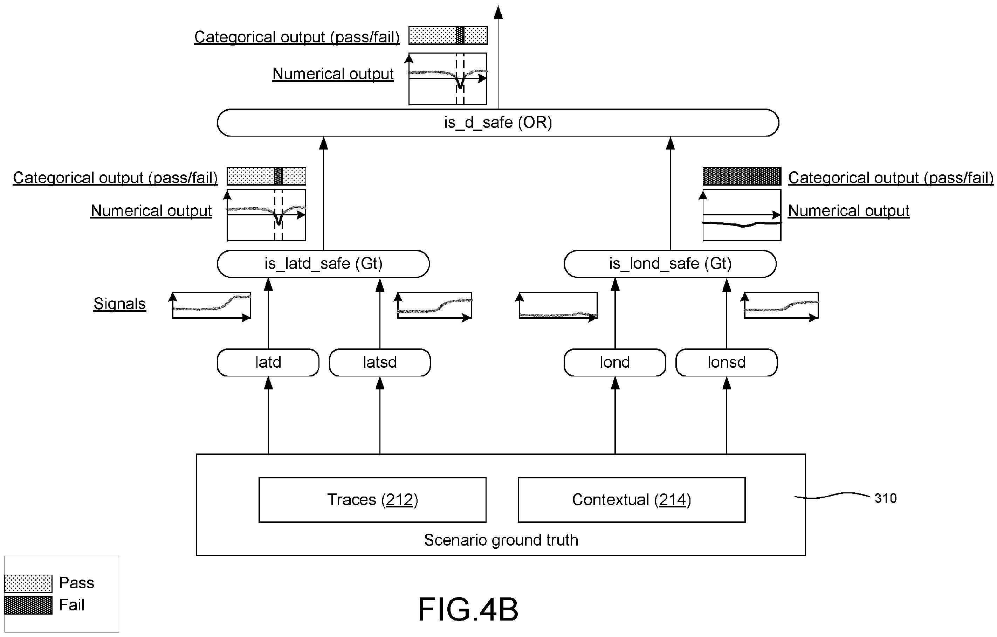

Figure 4B shows an example of a rule tree that includes a lateral distance branch corresponding to that of Figure 4A. Additionally, the rule tree includes a longitudinal distance branch, and a top-level OR predicate (safe distance node, is_d_safe) to implement a safe distance metric. Similar to the lateral distance branch, the longitudinal distance brand extracts longitudinal distance and longitudinal distance threshold signals from the scenario data (extractor nodes lond and lonsd respectively), and a longitudinal safety assessor node (is_lond_safe) returns TRUE when the longitudinal distance is above the safe longitudinal distance threshold. The top-level OR node returns TRUE when one or both of the lateral and longitudinal distances is safe (below the applicable threshold), and FALSE if neither is safe. In this context, it is sufficient for only one of the distances to exceed the safety threshold (e.g. if two vehicles are driving in adjacent lanes, their longitudinal separation is zero or close to zero when they are side-by-side; but that situation is not unsafe if those vehicles have sufficient lateral separation).

The numerical output of the top-level node could, for example, be a time-varying robustness score.

Different rule trees can be constructed, e.g. to implement different rules of a given safety model, to implement different safety models, or to apply rules selectively to different scenarios (in a given safety model, not every rule will necessarily be applicable to every scenario; with this approach, different rules or combinations of rules can be applied to different scenarios). Within this framework, rules can also be constructed for evaluating comfort (e.g. based on instantaneous acceleration and/or jerk along the trajectory), progress (e.g. based on time taken to reach a defined goal) etc.

The above examples consider simple logical predicates evaluated on results or signals at a single time instance, such as OR, AND, Gt etc. However, in practice, it may be desirable to formulate certain rules in terms of temporal logic.

Hekmatnejad et al., "Encoding and Monitoring Responsibility Sensitive Safety Rules for Automated Vehicles in Signal Temporal Logic" (2019), MEMOCODE '19: Proceedings of the 17th ACM-IEEE International Conference on Formal Methods and Models for System Design discloses a signal temporal logic (STL) encoding of the RSS safety rules. Temporal logic provides a formal framework for constructing predicates that are qualified in terms of time. This means that the result computed by an assessor at a given time instant can depend on results and/or signal values at another time instant(s).

For example, a requirement of the safety model may be that an ego agent responds to a certain event within a set time frame. Such rules can be encoded in a similar manner, using temporal logic predicates within the rule tree.

In the above examples, the performance of the stack 100 is evaluated at each time step of a scenario. An overall test result (e.g. pass/fail) can be derived from this - for example, certain rules (e.g. safety-critical rules) may result in an overall failure if the rule is failed at any time step within the scenario (that is, the rule must be passed at every time step to obtain an overall pass on the scenario). For other types of rule, the overall pass/fail criteria may be "softer" (e.g. failure may only be triggered for a certain rule if that rule is failed over some number of sequential time steps), and such criteria may be context dependent.

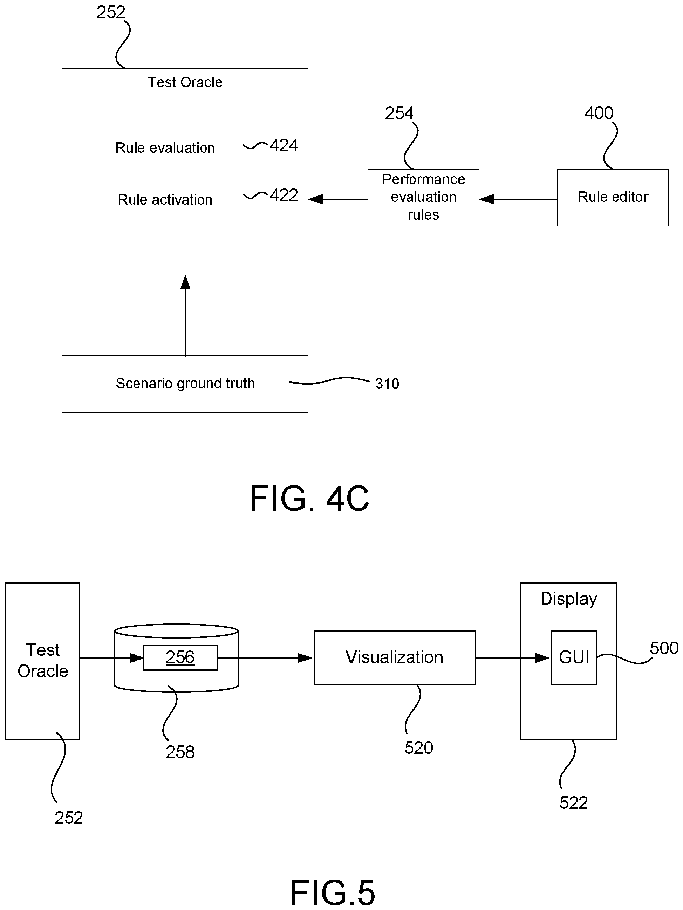

Figure 4C schematically depicts a hierarchy of rule evaluation implemented within the test oracle 252. A set of rules 254 is received for implementation in the test oracle 252.

Certain rules apply only to the ego agent (an example being a comfort rule that assesses whether or not some maximum acceleration or jerk threshold is exceeded by the ego trajectory at any given time instant).

Other rules pertain to the interaction of the ego agent with other agents (for example, a "no collision" rule or the safe distance rule considered above). Each such rule is evaluated in a pairwise fashion between the ego agent and each other agent. As another example, a "pedestrian emergency braking" rule may only be activated when a pedestrian walks out in front of the ego vehicle, and only in respect of that pedestrian agent.

Not every rule will necessarily be applicable to every scenario, and some rules may only be applicable for part of a scenario. Rule activation logic 422 within the test oracle 422 determines if and when each of the rules 254 is applicable to the scenario in question, and selectively activates rules as and when they apply. A rule may, therefore, remain active for the entirety of a scenario, may never be activated for a given scenario, or may be activated for only some of the scenario. Moreover, a rule may be evaluated for different numbers of agents at different points in the scenario. Selectively activating rules in this manner can significantly increase the efficiency of the test oracle 252.

The activation or deactivation of a given rule may be dependent on the activation/deactivation of one or more other rules. For example, an "optimal comfort" rule may be deemed inapplicable when the pedestrian emergency braking rule is activated (because the pedestrian's safety is the primary concern), and the former may be deactivated whenever the latter is active.

Rule evaluation logic 424 evaluates each active rule for any time period(s) it remains active. Each interactive rule is evaluated in a pairwise fashion between the ego agent and any other agent to which it applies.

There may also be a degree of interdependency in the application of the rules. For example, another way to address the relationship between a comfort rule and an emergency braking rule would be to increase a jerk/acceleration threshold of the comfort rule whenever the emergency braking rule is activated for at least one other agent.

Whilst pass/fail results have been considered, rules may be non-binary. For example, two categories for failure - "acceptable" and "unacceptable" - may be introduced. Again, considering the relationship between a comfort rule and an emergency braking rule, an acceptable failure on a comfort rule may occur when the rule is failed but at a time when an emergency braking rule was active. Interdependency between rules can, therefore, be handled in various ways.

The activation criteria for the rules 254 can be specified in the rule creation code provided to the rule editor 400, as can the nature of any rule interdependencies and the mechanism(s) for implementing those interdependencies.

**Graphical user interface:**

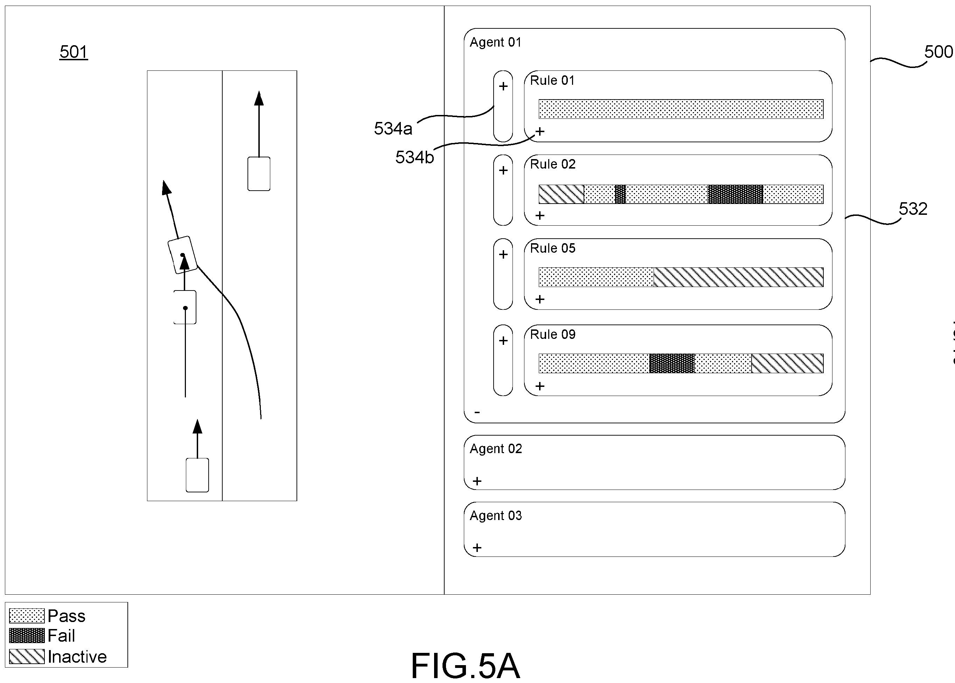

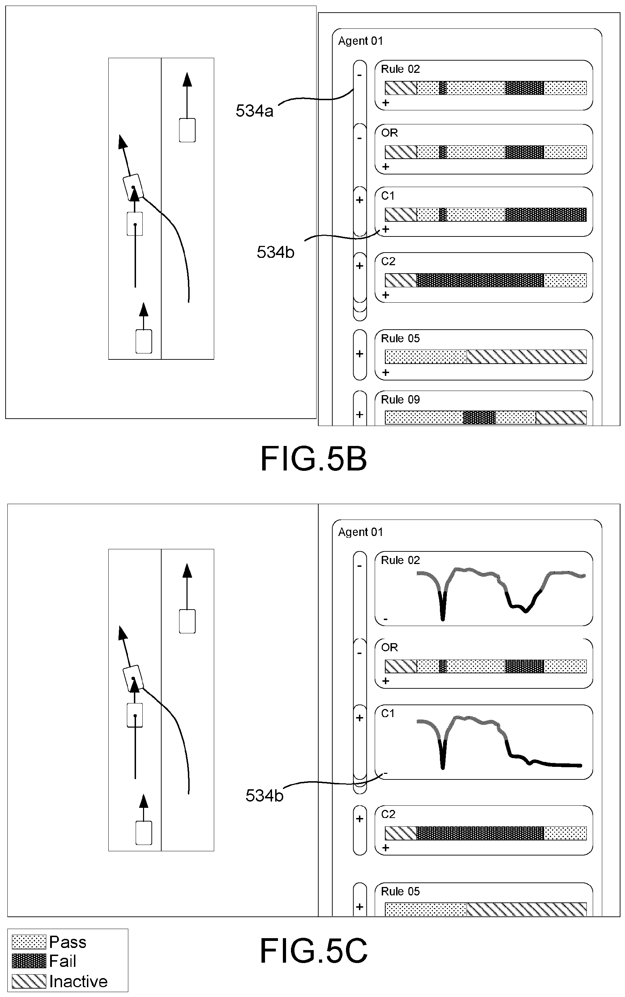

Figure 5 shows a schematic block diagram of a visualization component 520. The visualization component is shown having an input connected to the test database 258 for rendering the outputs 256 of the test oracle 252 on a graphical user interface (GUI) 500. The GUI is rendered on a display system 522.

Figure 5A shows an example view of the GUI 500. The view pertains to a particular scenario containing multiple agents. In this example, the test oracle output 526 pertains to multiple external agents, and the results are organized according to agent. For each agent, a time-series of results is available for each rule applicable to that agent at some point in the scenario. In the depicted example, a summary view has been selected for "Agent 01", causing the "top-level" results computed to be displayed for each applicable rule. There are the top-level results computed at the root node of each rule tree. Colour coding is used to differentiate between periods when the rule is inactive for that agent, active and passes, and active and failed.

A first selectable element 534a is provided for each time-series of results. This allows lower-level results of the rule tree to be accessed, i.e. as computed lower down in the rule tree.

Figure 5B shows a first expanded view of the results for "Rule 02", in which the results of lower-level nodes are also visualized. For example, for the "safe distance" rule of Figure 4B, the results of the "is_latd_safe node" and the "is_lond_safe" nodes may be visualized (labelled "C1" and "C2" in Figure 5B). In the first expanded view of Rule 02, it can be seen that success/failure on Rule 02 is defined by a logical OR relationship between results C1 and C2; Rule 02 is failed only when failure is obtained on both C1 and C2 (as in the "safe distance" rule above).

A second selectable element 534b is provided for each time-series of results, that allows the associated numerical performance scores to be accessed.

Figure 5C shows a second expanded view, in which the results for Rule 02 and the "C1" results have been expanded to reveal the associated scores for time period(s) in which those rules are active for Agent 01. The scores are displayed as a visual score-time plot that is similarly colour coded to denote pass/fail.

**Example scenarios:**

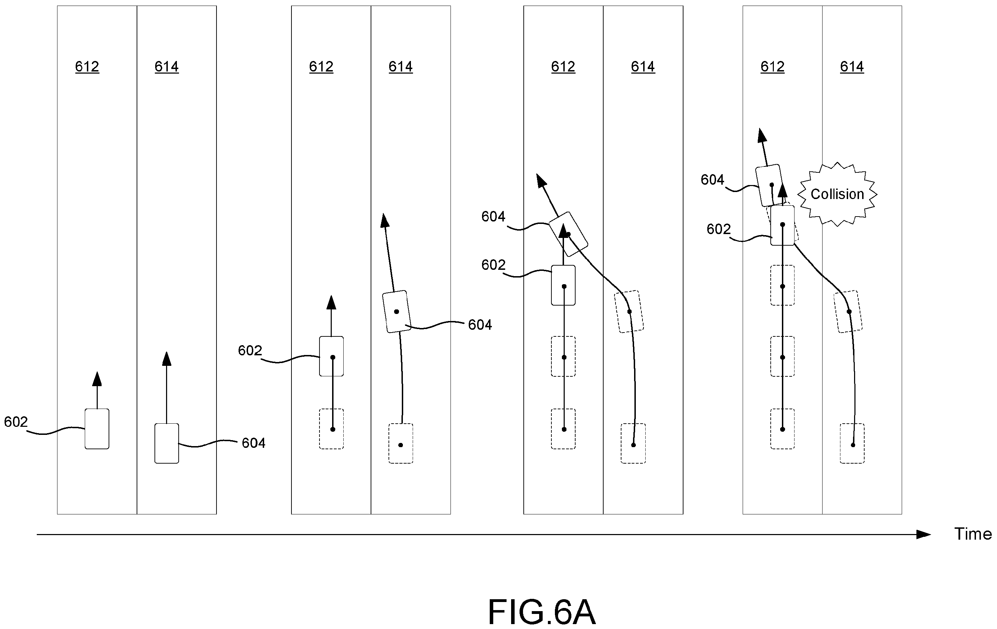

Figure 6A depicts a first instance of a cut-in scenario in the simulator 202 that terminates in a collision event between an ego vehicle 602 and another vehicle 604. The cut-in scenario is characterized as a multi-lane driving scenario, in which the ego vehicle 602 is moving along a first lane 612 (the ego lane) and the other vehicle 604 is initially moving along a second, adjacent lane 604. At some point in the scenario, the other vehicle 604 moves from the adjacent lane 614 into the ego lane 612 ahead of the ego vehicle 602 (the cut-in distance). In this scenario, the ego vehicle 602 is unable to avoid colliding with the other vehicle 604. The first scenario instance terminates in response to the collision event.

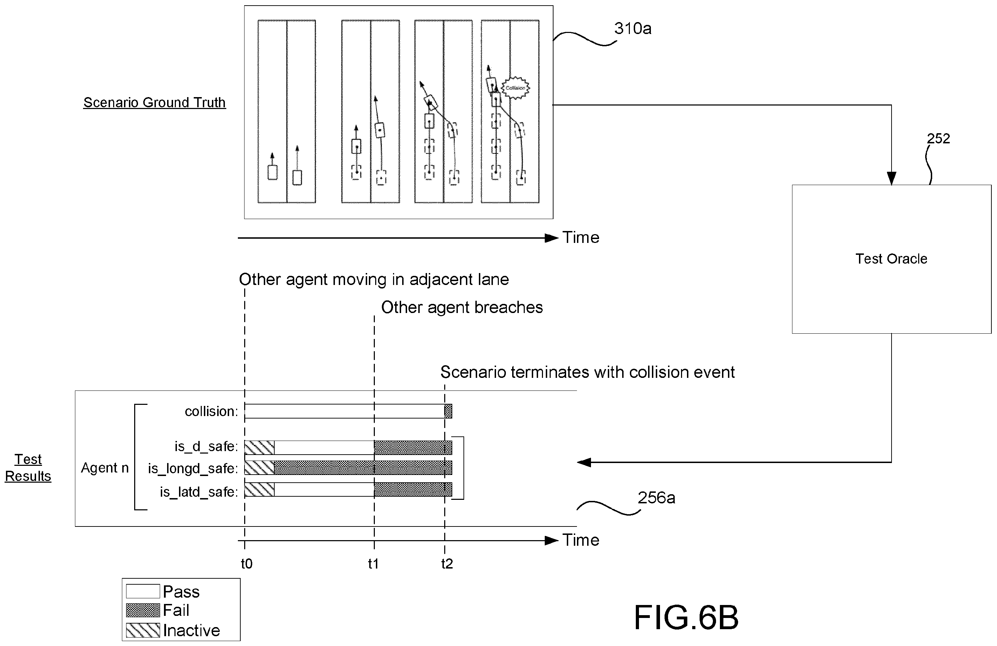

Figure 6B depicts an example of a first oracle output 256a obtained from ground truth 310a of the first scenario instance. A "no collision" rule is evaluated over the duration of the scenario between the ego vehicle 602 and the other vehicle 604. The collision event results in failure on this rule at the end of the scenario. In addition, the "safe distance" rule of Figure 4B is evaluated. As the other vehicle 604 moves laterally closer to the ego vehicle 602, there comes a point in time (t1) when both the safe lateral distance and safe longitudinal distance thresholds are breached, resulting in failure on the safe distance rule that persists up to the collision event at time t2.

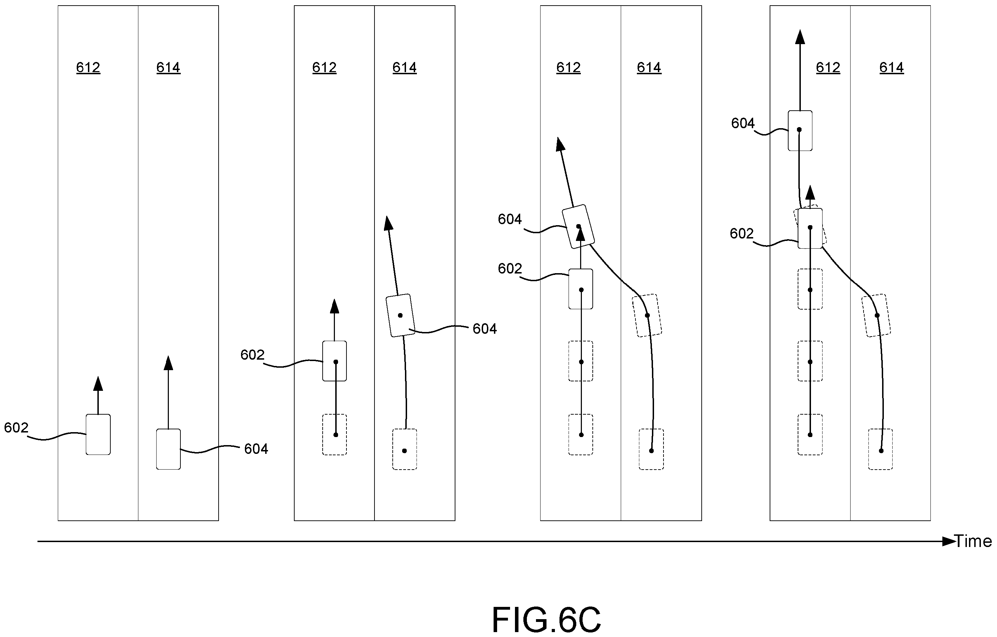

Figure 6C depicts a second instance of the cut-in scenario. In the second instance, the cut-in event does not result in a collision, and the ego vehicle 602 is able to reach a safe distance behind the other vehicle 604 following the cut in event.

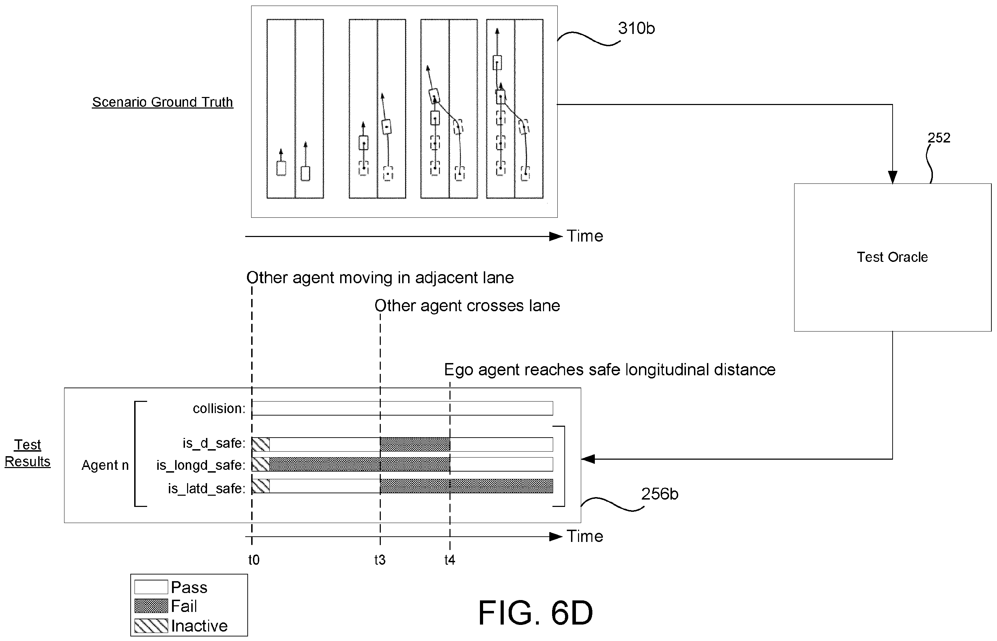

Figure 6D depicts an example of a second oracle output 256b obtained from ground truth 310b of the second scenario instance. In this case, the "no collision" rule is passed throughout. The safe distance rule is breached at time t3 when the lateral distance between the ego vehicle 602 and the other vehicle 604 becomes unsafe. However, at time t4, the ego vehicle 602 manages to reach a safe distance behind the other vehicle 604. Therefore, the safe distance rule is only failed between time t3 and time t4.

**Goal or behaviour recognition through inverse planning:**

Further details of the inverse planning method implemented by the goal recognition component 156 of Figure 1C will now be described.

Inverse planning may be implemented at the maneuver level, in order to make a probabilistic prediction about a current maneuver of an non-ego agent. For example, goal recognition component 156 may predict a probability distribution $P(M|\tau)$ over a set of available maneuvers $M$, such as "follow lane", "switch lane" switch lane etc., given a set of relevant observations comprising (or derived from) the trace $\tau$. Inverse planning at the maneuver-level is a form of (probabilistic) maneuver detection.

Alternatively or additionally, inverse planning may be implemented at the goal-level, in order to make a probabilistic prediction about a current goal of a non-ego agent. For example, the goal recognition component 156 may predict a probability distribution $P(G|O)$ over a set of available goals $G$. For example, in driving scenario with a left turn, the goals could be a "turn left" goal or a "continue straight" goal (i.e. remain on the current road and do not take the left turn), captured as suitable goal locations. Inverse planning at the goal-level is a form of (probabilistic) goal recognition.

Goal recognition and maneuver detection will typically operate on different time scales. Goal recognition generally considers longer time periods into the future than maneuver detection. For example, maneuver prediction may look a few second (e.g. of order 5s) into the future, whereas goal recognition could (depending on the circumstances) look further ahead than this. Hence, goal recognition will generally consider longer trajectories (i.e. trajectories further into the future) than maneuver recognition.

A goal may for example be captured as a desired location (reference point) on a map, which the ego vehicle is attempting to reach from a current location on the map. For example the desired location may be defined in relation to a particular junction, lane layout, roundabout exit etc. The map, in this context, refers to the static road layout of a scenario description 201a. For example, the map could be encoded in a static layer of the scenario description to which different dynamic layers can be applied.

When implemented at the goal-level, inverse planning hypothesises different possible goals for each non-ego agent in question, and then generates trajectories of how the agent might achieve each goal, and the likelihood that it would follow each trajectory. An underlying assumption is that each non-ego agent will act in a manner that can be predicted using a generative model.

The term "inverse planning" refers to this underlying assumption that a non-ego agent will plan its decisions in a predictable manner. More formally, the assumption is that the other vehicle will plan and execute with a generative model that can be hypothesised.

An inverse planning method that will now be described with reference to Figure 2, which shows a flow chart for the method. This considers inverse planning at the goal level but the underlying principles apply equally to inverse planning at the maneuver level. The method is applied by the goal recognition component 156 to the other agent trace(s) extracted in the ground truthing pipeline 142.

The following steps are performed for each of the one or more none-ego agents under consideration, those actors being vehicles other than the AV in the following examples. Other vehicles are considered in the following examples, but the techniques can also be used to infer goals/behaviours of other types of anent (pedestrians, cyclists, animals etc.).

At step SB2, a set of hypothesised goals is determined for the other vehicle in question. An assumption is that the other vehicle is currently executing one of these goals. In order to determine an appropriate set of hypothesised goals, a driving context, such as the road-layout in the vicinity of the other vehicle, is determined.

Non-ego agent goals may be hypothesised based on the road layout. For example, given a set of non-ego vehicles in the vicinity of a road junction, roundabout or other road layout indicated on the map (the driving context), suitable goals may be hypothesised from the road layout alone (without taking into account any observed historical behaviour of the agent). By way of example, if the other vehicle is currently driving on a multi-lane road, with no nearby junctions, the set of hypothesised goals may consist of "follow lane" and "switch lane". As another example, with a set of non-ego agents in the vicinity of a left-turn junction, the hypothesised goals may be turn left and continue straight. As indicated, such goals are defined with reference to suitable reference points on the map.

However, goals may be hypothesised in various ways. For example, observed historical behaviour (such as a trace observed prior to time $t$) may be taken into account in hypothesising non-ego agent goals, or a combination of map-based and historical behaviour-based inference may be used to hypothesise the goals.

Note that, even when historical behaviour is not used to hypothesise the available goals, it is nonetheless used to determine the likelihood of each of those goals (see below).

Having determined the set of hypothesised goals, the following steps are performed for each of those goals.

At step SB4, an expected trajectory model is determined for the hypothesised goal in question. The expected trajectory model is a model that simulates future behaviour of the other vehicle on the assumption that it is executing that particular goal. In particular, the expected trajectory model indicates how likely it is that the other vehicle will take a particular trajectory or trajectories within a given time period $\Delta t$ (from time $t$ to time $t + \Delta t$) assuming that it is executing that goal during that time period $\Delta t$. As indicated, the goal the vehicle is executing may be parameterized by an end point based on the map. For example, if the goal is to continue straight (rather than, say, turn left) the end point may be a point on the road at a set distance, say 40m, ahead of the vehicle in the same lane. Alternatively, in e.g. a multi-lane scenario, the goal location could be some distance along the road ahead without specifying a specific lane (see below for further details).

The expected trajectory model may simply be a (single) predicted for a given goal, but in the present examples it takes the form of a predicted trajectory distribution for the goal in question. The predicted trajectory distribution is provided for each goal in the present instance by synthesizing a discrete set of $n$ predicted trajectories for the goal in question given a location $r_t$ of the non-ego vehicle at time $t$, thereby providing a predicted trajectory distribution for at least the time interval $\Delta t$.

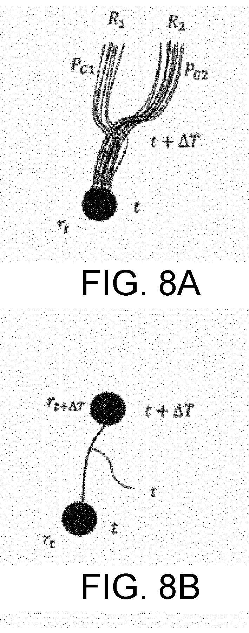

By way of example, Figure 8A shows respective sets of predicted trajectory $P_{G1}$, $P_{G2}$ for goals $G1$ and $G2$ respectively as predicted for a particular non-ego vehicle. The goals $G_1$, $G_2$ are defined with respect to reference locations $R_1$, $R_2$ respectively in the map frame of reference, which can be points or areas on the map. Given the location $r_t$ of the non-ego vehicle at time $t$ and the reference points $R_1$, $R_2$ of each goal, the predicted trajectory sets $P_{G1}$, $P_{G2}$ are synthesized for goals $G_1$, $G_2$ respectively.

Although in this example, each goal is defined simply with respect to a single reference point/area, as will be appreciated, goals can be defined in other ways, for example with reference to multiple reference points as appropriate in the circumstances. In general, a goal is defined by a set of one or more goal parameters, which in turn are generally defined in the map frame of reference in the context of autonomous driving. A reference location in the map frame of reference is one example of a goal parameter, and all description pertaining to such reference locations applies equally to other types of goal parameter.

Following the left turn example, one set of trajectories would be generated for the "continue straight" goal, which are trajectories it is predicted the other vehicle might take were it executing the "continue" goal, and another set of trajectories would be generated for the "turn left" goal, which are trajectories it is predicted the other vehicle might take were it executing the "turn left" goal.

At step SB6, the trace of the other vehicle as actually observed over the time period $\Delta t$ (i.e. between time $t$ and $t + \Delta t$) is matched to the distribution of trajectories associated with the goal in question for that time period $\Delta t$, in order to determine a likelihood for that goal.

By way of example, Figure 8B shows an actual observed trace $\tau$ of the vehicle in question between time $t$ and $t + \Delta t$. The observed trace $\tau$ is (one of) the non-ego trace(s) 144b of Figure 8C. In the present "offline" context, $\Delta t$ can be any period for which trace data is available. There is no requirement for the method to run in real-time in this context, as the aim is to infer a goal for the purpose of subsequent simulation.

By matching the actual trace $\tau$ to the predicted trajectory distribution for each of the goals $G_1$, $G_2$ (Figure 8A) a likelihood of each goal $G_1$, $G_2$ can be determined probabilistically for the time interval $\Delta t$. This can be a form of soft-matching. The goal likelihood can be captured as a conditional probability of each hypothesised goal $G_i$ given the observed trace $\tau$ of the non-ego vehicle, i.e. $p(G_i|\tau)$, which is the estimated probability that the non-ego vehicle was executing that goal $G_i$ over the time interval $\Delta t$ given the observed trace $\tau$.

In other words, the goal recognition component 156 predicts, for each of the hypothesised goals, a set of one or more possible trajectories that the other vehicle might have taken in the time interval $\Delta t$ and a likelihood of each trajectory, on the assumption that the other vehicle was executing that goal during that time period (i.e. what the other vehicle might have done during time interval $\Delta t$ had it been executing that goal). This is then compared with the actual trace of the other vehicle within that time period (i.e. what the other vehicle actually did), to determine a likelihood of each goal for the time period $\Delta t$.

Further details of a particular implementation of inverse planning are described below. First, a more formal mathematical formulation of the inverse planning framework is described.

II. PRELIMINARIES AND PROBLEM DEFINITION

Let $\mathcal{I}$ be the set of vehicles interacting with the ego vehicle in a local neighbourhood (including the ego vehicle). At time $t$, each vehicle $i \in \mathcal{I}$ is in a local state $s_t^i \in \mathcal{S}^i$, receives a local observation $o^i \in \mathcal{O}^i$ and can choose an action $a^i \in \mathcal{A}^i$. The joint state (of the ego vehicle and the agent(s)) is denoted as $s_t \in \mathcal{S} = \times_i \mathcal{S}^i$. The notation $s_{a:b}$ is used to denote the tuple $(s_a, \ldots, s_b)$, and similarly for $o_t \in \mathcal{O}$, $a_t \in \mathcal{A}$. Observations depend on the joint state via $p(o^i|s_t)$, and actions depend on the observations via $p(a_t^i|o_{1:t}^i)$. A local state contains a vehicle's pose, velocity, and acceleration (herein, velocity and speed are used interchangeably); an observation contains the poses and velocities of nearby vehicles; and an action controls the vehicle's steering and acceleration.

The probability of a sequence of joint states $s_{1:n}$, $n \geq 1$, is given by

$$p(s_{1:n} = \prod_{t=1}^{n-1} \int_{\mathcal{O}} \int_{\mathcal{A}} p(o_t|s_t)p(a_t|o_{1:t})p(s_{t+1}|s_t, a_t)do_t da_t \qquad (1)$$

where $p(s_{t+1}|s_t, a_t)$ defines the joint vehicle dynamics, and independent local observations and actions are assumed:

$$p(o_t|s_t) = \prod_i p(o_t^i|s_t) \text{ and } p(a_t|o_{1:t}) = \prod_i p(a_t^i|o_{1:t}^i).$$

Vehicles react to other vehicles via their local observations $o_{1:n}^i$.

A planning problem is defined as finding an optimal "policy" $\pi^*$ which selects actions for an ego vehicle, $\varepsilon$, to achieve a specified goal, $g^\varepsilon$, while optimising a driving trajectory via a defined reward function.

A policy is a function $\pi: (\mathcal{O}^\varepsilon) \mapsto \mathcal{A}^\varepsilon$ which maps an observation sequence $o_{1:n}^\varepsilon$ (observed trajectory) to an action $a_t^\varepsilon$. A goal can be any (partial) state description $g^\varepsilon \subset \mathcal{S}^\varepsilon$, though, by way of example, the following description focuses on goals that specify target locations. Formally, define

$$\Omega_n = \{ s_{1:n}|s_n^\varepsilon \subseteq g^\varepsilon \wedge \nexists \, m < n : s_m^\varepsilon \subseteq g^\varepsilon \} \qquad (2)$$

where $s_n^\varepsilon \subseteq g^{\wedge\varepsilon}$ means that $s_n^\varepsilon$ satisfies $g^\varepsilon$. The second condition in (2) ensures that $\sum_{n=1}^\infty \int_{\Omega_n} p(s_{1:n})ds_{1:n} \leq 1$ for any policy $\pi$, which ensures soundness of the sum in (3). The problem is to find $\pi^*$ such that

$$\pi^* \in \arg\max_\pi \sum_{n=1}^\infty \int_{\Omega_n} p(s_1:n)R^\varepsilon(s_{1:n})ds_{1:n} \qquad (3)$$

Where $R^i(s_{1:n})$is the reward of $s_{1:n}$ for vehicle i (See Section III-E, below). Intuitively, maximizing (3) entails optimising the probability of achieving the goal and the rewards of the generated trajectories. In the described implementation, (3) is approximated using a finite planning horizon (detailed in Section III-G).

While the experiments detailed in Annex A used scenarios with fixed goals, the above problem formulation allows the method to drive through full routes with a route planner module continually updating the goal location $g^\varepsilon$ of the ego vehicle depending on its current location on the route.

III. METHOD

A. *System Overview*

The described approach relies on two assumptions: (1) each vehicle seeks to reach some (unknown) goal location from a set of possible goals, and (2) each vehicle follows a plan generated from a finite library of defined maneuvers.

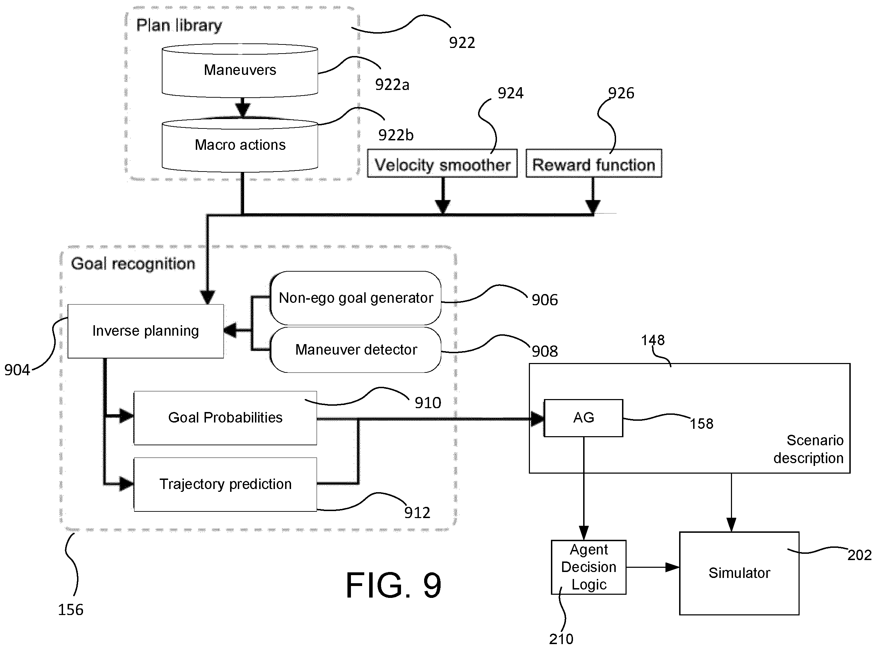

Figure 9 shows further details of the goal recognition component 156 in one example implementation. For each non-ego vehicle, the goal recognition component 156 enumerates its possible goals and inversely plans for that vehicle to each goal, giving the probabilities and predicted trajectories to the goals.

The following sections describes each of the sub-components of the goal recognition component 156 shown in Figure 9 in further detail. The various sub-components depicted in Figure 9 cooperate, as described below, to provide the agent goal data 158 to be used in stimulation in the manner described above.

B. *Maneuvers*

It is assumed that, at any time, each vehicle is executing one of a finite number of maneuvers 920a. The examples below use the following maneuvers: *lane-follow, lane-change-left/right, turn-left/right, give-way, stop.*

Each maneuver $\omega$ specifies applicability and termination conditions. A maneuver is available in a given state if and only if the state satisfies an applicability condition of the maneuver. For example, lane-change-left is only applicable if there is a lane in same driving direction on the left of the vehicle (one could also check for space constraints). The maneuver terminates if the state satisfies the termination condition.

If applicable, a maneuver specifies a local trajectory $\hat{s}^i_{1:n}$ to be followed by the vehicle, which includes a reference path in the global coordinate frame and target velocities along the path. For convenience in exposition, it is assumed that $\hat{s}^i$ uses the same representation and indexing as $s^i$ but in general this does not have to be the case (for example, $\hat{s}$ may be indexed by longitudinal position rather than time, which can be interpolated to time indices). In the present example, the reference path is generated via a Bezier spline function fitted to a set of points extracted from the road topology, and target velocities are set using domain heuristics similar to [10]. Generally, goal recognition component 156 assumes that vehicles will attempt to drive at local speed limit when possible. This target is reduced to the velocity of the slower vehicle in front on same lane (if any) or as a function of local curvature on the driving path.

The give-way maneuver slows the vehicle down to some specified velocity while driving toward a given location, usually a crossing or turning point where oncoming traffic has priority. At the location, the maneuver terminates if the specified lanes are clear (allowing the vehicle to proceed with next maneuver without fully stopping), otherwise it fully stops the vehicle and then terminates once the specified lanes are clear. Give-way is permitted to terminate early if safe entry is predicted.

The lane-follow and give-way maneuvers have open parameters in their termination conditions: for lane-follow, the parameter specifies the driving distance; for give-way, the parameter specifies lanes which must be monitored for oncoming traffic. Such open parameters are automatically set by macro actions, which we define in next section.

*C. Macro Actions*

Macro actions 922b concatenate one or more maneuvers in a flexible way. Using macro actions relieves the planner in two important ways: they specify common sequences of maneuvers, and they automatically set the free parameters in maneuvers based on context information (usually road layout). Table I defines examples of the macro actions 922b. The applicability condition of a macro action is given by the applicability condition of the first maneuver in the macro action as well as optional additional conditions (see Table I). The termination condition of a macro action is given by the termination condition of the last maneuver in the macro action.

Note that macro actions as used in this context do not define a hierarchy of decomposable actions; they simply define sequences of actions.

In the present example, inverse planning searches over macro actions rather than maneuvers, which significantly increases their efficiency by reducing search depth.

Table 1: Macro actions used in our system. Each macro action concatenates one or more maneuvers and sets their parameters (see Sec. III-C)

| Macro action | Additional applicability condition | Maneuver sequence (maneuver parameters in brackets) |
|---|---|---|
| *Continue* | | *lane-follow* (end of visible lane) |
| *Continue to new exit* | Must be in roundabout and not in outer-lane | *Lane-follow* (next exit point) |
| *Change left/right* | There is a lane to the left/right | *lane-follow* (until target lane clear, *lane-change-left/-right* |
| *Exit left/right* | Exit point on same lane ahead of car and in correct direction | *Lane-follow* (exit point), *give-way* (relevant lanes), *turn-left/right* |
| *Stop* | There is a stopping goal ahead of the car on the current lane | *Lane-follow* (close to stopping point), *stop* |

*D. Velocity Smoothing*

To accommodate natural variations in driving behaviours and to obtain a feasible trajectory across maneuvers for a vehicle i, a velocity smoothing function 924 is applied to optimise the target velocities in a given trajectory $\hat{s}^i_{1:n}$ Let $\hat{x}_t$ be the longitudinal position on the reference path at $\hat{s}^i_t$ and $\hat{v}_t$ its corresponding target velocity, for $1 \leq t \leq n$. A piecewise linear interpolation of target velocities between points is denoted by $\kappa: x \to v$. Given the time elapsed between two time

steps, $\Delta t$; the maximum velocity and acceleration, $v_{max}/a_{max}$; and setting $x_1 = \hat{x}_1$, $v_1 = \hat{v}_1$, a smoothing problem is defined as

$$\min_{x_{2:n},v_{2:n}} \sum_{t=1}^{n} \left\| v_t - \kappa(x_t) \right\|_2 + \lambda \sum_{t=1}^{n-1} \left\| v_{t+1} - v_t \right\|_2 \qquad (4)$$

$$x_{t+1} = x_t + v_t \Delta t$$

$$0 < v_t < v_{max}$$

$$v_t \leq \kappa(x_t)$$

where $\lambda > 0$ is the weight given to the acceleration part of the optimisation objective. The last constraint to treat target velocities as upper bounds results in more realistic braking behaviours.

Equation (4) is a nonlinear non-convex optimisation problem which can be solved, e.g., using a primal-dual interior point method (e.g. IPOPT [27]). From the solution of the problem, $(x_{2:n}, v_{2:n})$, the goal recognition component 156 interpolates to obtain achievable velocities at the original points $\hat{x}_t$. If $\hat{x}_t \leq x_n$ for all $t$, then the goal recognition component 156 can interpolate from this solution for $\hat{x}_{1:n}$. Otherwise, the goal recognition component 156 can solve a similar problem starting from $x_n$, and repeat the procedure until all $\hat{x}_{1:t}$ are within the bound.

Velocity smoothing should respect zero-velocities in the input trajectory, which indicate full stops. A simple way of achieving this is to split a trajectory into segments separated by stopping events, and to apply the smoothing function to each segment.

*E. Reward Function*

As noted, "reward function" and "cost function" are two ways of describing the same thing, namely a function 926 that penalizes (i.e. discourages) certain trajectory features and rewards (i.e. encourages) others. How the output of the function 926 (the reward or cost of a given trajectory) is represented numerically is immaterial, and the choice of a particular terminology (reward or cost) does not imply any particular numerical representation. Lower numerical values could represent a lower cost/higher reward or a higher cost/lower reward than higher numerical values, and the choice of terminology does not imply any restriction on this. The only requirement is that the numerical representation is consistent with the way any cost/reward optimization is performed.

In the present example, a reward of a trajectory $s_{1:n}$ for vehicle i is defined as a weighted sum of K reward components,

$$R^i(s_{1:n}) = \sum_{k=1}^{K} w_k R_k^i(s_{1:n}) \qquad (5)$$

with weights $w_k > 0$ and $R_k^i(s_{1:n}) > 0$. The goal recognition component 156 includes reward components for execution time, longitudinal jerk, lateral jerk, path curvature, and safety distance to leading vehicle. Here, $R^i$ represents the reward function 926 for goal $g_i$ in mathematical notation.

*F. Goal Recognition*

By assuming that each vehicle $i \in \mathcal{J}$ seeks to reach one of a finite number of possible goal locations $g^i \in \mathcal{G}^i$, using plans constructed from our defined macro actions, an inverse planner 904 uses a framework of rational inverse planning to compute a Bayesian posterior distribution over vehicle i's goals at time t (the goal probabilities 910),

$$p(g^i | s_{1:t}) \propto L(s_{1:t} | g^i) p(g^i) \qquad (6)$$

Where $L(s_{1:t}|g^i)$ is the likelihood of i's observed trajectory given goal $g^i$, and $p(g^i)$ specifies a prior probability of the goal $g^i$.

The likelihood is a computed as function of the reward difference between two plans: the reward $\hat{r}$ of the optimal trajectory from i's initial observed state $s_1^i$ to goal $g^i$ after velocity smoothing, and the reward $\bar{r}$ of the trajectory which follows the observed trajectory until time $t$ and then continues optimally to goal $g^i$ with smoothing applied only to the trajectory after $t$. Then, the likelihood is defined as

$$L\left(s_{1:t}\middle|g^i\right) = \exp(-\beta(\bar{r} - \hat{r})$$

where $\beta$ is a scaling parameter (e.g. $\beta = 1$). This definition assumes that vehicles behave rationally by driving optimally to achieve goals, but allows for a degree of deviation. If a goal cannot be achieved, we its probability is set to zero.

Velocity smoothing is not applied to the part of the trajectory that has already been observed, i.e. $s_{1:t}$. Otherwise, the effect of velocity smoothing could be to wash out evidence that would hint at certain goals.

Algorithm 1 shows pseudo code for an implementation of the goal recognition algorithm, with further details in below subsections. The algorithm allows for efficient parallel processing by using parallel threads for each vehicle i, goal $g^i$ and rewards $\hat{r}, \bar{r}$.

*Algorithm 1: Goal recognition algorithm:*

Input: vehicle $i$, current maneuver $\omega^i$, observations $s_{1:t}$

Returns: goal probabilities $p\left(g^i\middle|s_{1:t}, \omega^i\right)$

1. Generate possible goals $g^i \in \mathcal{G}^i$ from state $s_t^i$

2. Set prior probabilities $p\left(g^i\right)$ (e.g. uniform)

3. For all $g^i \in \mathcal{G}^i$ do:

   $\hat{s}_{1:n}^i \leftarrow A * SEARCH\left(\omega^i\right)$ from $\hat{s}_1^i$ to $g^i$

   Apply velocity smoothing to $\hat{s}_{1:n}^i$

   $\hat{r} \leftarrow$ reward $R^i\left(\hat{s}_{1:n}^i\right)$

   $\bar{s}_{1:m}^i \leftarrow A * SEARCH(\omega^i)$ from $\bar{s}^i$ to $g^i$, with $\bar{s}_{1:t}^i = s_{1:t}^i$

   Apply velocity smoothing to $\bar{s}_{t+1:m}^i$

   $\bar{r} \leftarrow$ reward $R^i(\bar{s}_{1:m}^i)$

   $L\left(s_{1:t}\middle|G^i\right) \leftarrow \exp(-\beta(\bar{r} - \hat{r}))$

   Return $p\left(g^i\middle|s_{1:t}\right) \propto L(s_{1:t}|g^i)\, p(g^i)$

1) **Goal Generation**: A heuristic function is used to generate a set of possible goals $\mathcal{G}^i$ for vehicle i based on its location and context information such as road layout and traffic rules. The goal recognition component 156 defines one goal for the end of the vehicle's current road and goals for end of each reachable connecting road, bounded by the ego vehicle's view region. Infeasible goals, such as locations behind the vehicle, are not included.

In addition to static goals which depend only on the vehicle's location and road layout/rules, dynamic goals can be defined, e.g. which depend on current traffic. For example, in the dense merging scenario considered below in Annex A, stopping goals are dynamically added to model a vehicle's intention to allow the ego vehicle to merge in front of the vehicle.

2) **Maneuver Detection**: Maneuver detection is used to detect the current executed maneuver of a vehicle (at time t), allowing inverse planning to complete the maneuver before planning onward. A maneuver detection module of the goal recognition component 156 computes probabilities over current maneuvers, $p(\omega^i)$ for each vehicle $i$. One option is Bayesian changepoint detection algorithms such as CHAMP [19]. Maneuver detection methods are known *per se,* and are therefore not described in further detail. In the experiments detailed below, a simulated detector was used.

As different current maneuvers may hint at different goals, inverse planning is performed for each possible current maneuver for which $p(\omega^i) > 0$. Thus, each current maneuver produces its own posterior probabilities over goals, denoted by $p(g^i|s_{1:t}, \omega^i)$ For efficiency, the inverse planning may be limited to some subset of maneuvers such as the most-likely maneuver(s).

3) **Inverse Planning**: Inverse planning is done using A* search [12] over macro actions. A* starts after completing the current maneuver $\omega^i$ which produces the initial trajectory $\hat{s}_{1:\tau}$ Each search node $q$ corresponds to a state $s \in \mathcal{S}$, with initial node at state $\hat{s}_\tau$ and macro actions are filtered by their applicability conditions applied to s. A* chooses the next macro action leading to a node $q'$ which has lowest estimated total cost to goal $g^i$, given by $f(q') = l(q') + h(q')$.

Here, the term "cost" is used in keeping with standard A* terminology and to differentiate the simpler cost definition used by the A* search from the reward function defined in Sec. III-E. The cost $h$ is approximating the reward by considering only travel time (see below), which is sufficient for the purpose of the A* search. However, different forms of cost/reward can be defined in this context.

The cost $l(q')$ to reach node $q'$ is given by the driving time from i's location in the initial search node to its location in q', following the trajectories returned by the macro actions leading to q'. The cost heuristic $h(q')$ to estimate remaining cost from $q'$ to goal $g^i$ is given by the driving time from i's location in $q'$ to goal via straight line at speed limit. This definition of $h(q')$ is admissible as per A* theory, which ensures that the search returns an optimal plan. After the optimal plan is found, a complete trajectory $\hat{s}^i_{1:n}$ is extracted from the maneuvers in the plan and the initial segment $\hat{s}_{1:\tau}$ from the current maneuver.

To minimise the computational cost of inverse planning, in the present implementation, macro actions are executed using open-loop control. This means that trajectories are simulated using an idealised driving model which executes the trajectory with linearly-interpolated target velocities. Second, the goal recognition component 156 operates on the assumption that all other vehicles not planned for use a constant-velocity lane-following model after their observed trajectories. This assumption allows give-way maneuver and change left/right macro actions to predict when traffic will be clear. Third, no smoothing is applied during search and a surrogate cost definition based only on approximate driving time is used. Finally, there is no check for collisions during inverse planning; due to the use of open-loop control and constant velocities of other vehicles, there may be situations where collisions happen inevitably (note that predicted collisions are still detected and accounted for, just not in this specific context - see below). These simplifications result in a level of abstraction which has low computational cost and is sufficiently informative for the goal probabilities. However, it will be appreciated that this is merely one possible implementation, and that other design choices can be adopted in other implementations.

4) **Trajectory Prediction**: In this example, the goal recognition component 156 predicts multiple plausible trajectories 912 for a given vehicle and goal, rather than a single optimal trajectory. This is beneficial because there are situations in which different trajectories may be (near)optimal but may lead to different predictions which could require different behaviour on the part of the ego vehicle.

To predict multiple trajectories and associated probabilities to a given goal, a second A* search is run for a fixed amount of time and is free to compute a set of plans with associated rewards (up to some fixed number of plans). Any time A* search finds a node that reaches the goal, the corresponding plan is added to the set of plans. The A* search may find trajectories that do not reach the goal, but those are not added to the set of plans considered in the next stage. Given a set of computed trajectories $\left\{\hat{s}^i_{1:n} \middle| \omega^i, g^i\right\}_{k=1\ldots K}$ to goal $g^i$ with initial maneuver $\omega^i$ and associated reward $r_k = R^i\left(\hat{s}^{i,k}_{1:n}\right)$ after smoothing, a distribution is computed over the trajectories by using a Boltzmann distribution:

$$p\left(\hat{s}^{i,k}_{1:n}\right) = \eta \exp(\gamma r_k) \qquad (8)$$

where $\gamma$ is a scaling factor (e.g. $\gamma = 1$) and $\eta$ is a normaliser. This encodes the assumption that trajectories which are closer to optimal (in terms of their reward) are more likely.

**Example goal detection:**

By way of further illustration, an example computation of goal probabilities will now be described.

The following description refers to observations $O$, which comprise the observed states agent in the above context.

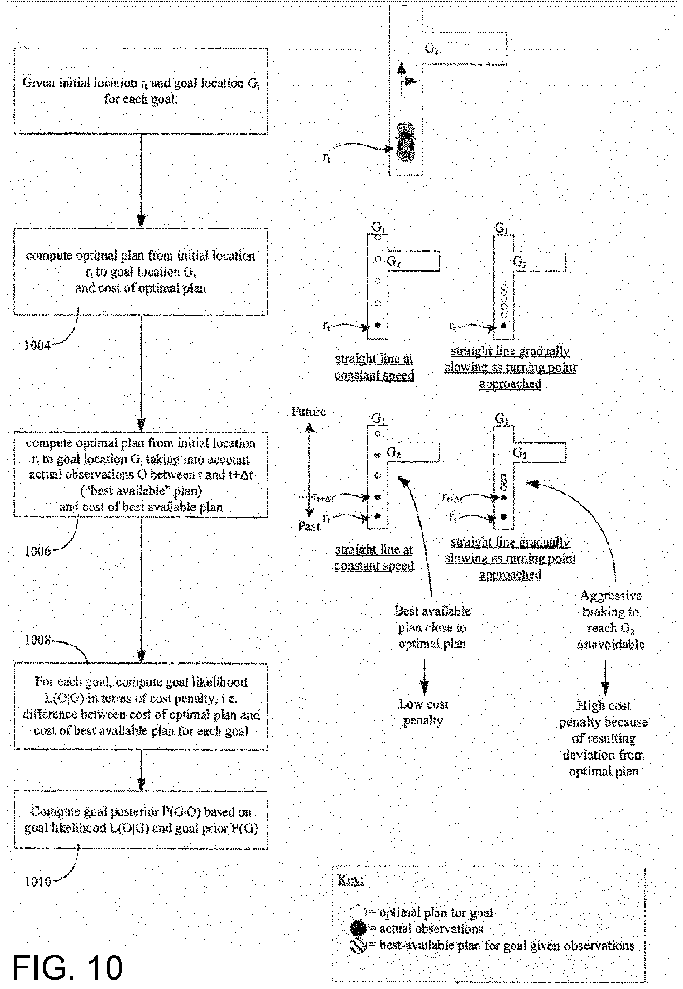

Figure 10 shows a schematic flowchart for an inverse planning method of probabilistically inferring a goal of a non-ego agent, from a finite set of available goals, based on reward differences. This is one example of an inverse planning method implemented by the inverse planner 904.

The right-hand side of Figure 10 shows an illustrative example of the steps applied to a scenario with two available goals:

1. $G_1$ - continuing along the current road, which is defined as a goal location at the end of the visible road (more generally, as a reference point ahead of the car on the current road);
2. $G_2$ - taking a right-turn exist, defined in terms of an exit location.

Given a set of possible goals for an observed car and a sequence of past basic maneuvers executed by the car, a posterior distribution over the goals can be computed using a process of inverse planning. As described above, the method computes a Bayesian posterior, $P(G|O) \sim L(O|G) P(G)$, over the possible goals $G$ given a sequence of observations $O$ (e.g. an observed trace $\tau_n$, as in the above examples), a prior distribution $P(G)$ over goals, and the likelihood function $L(O|G)$.

A goal is defined in terms of a goal location, and the notation $G_i$ may be used to represent the goal location for that region. The goal location $G_i$ can be a point in space, but can also be region or could correspond to a particular distance along the road, e.g. a goal location could be defined as a line perpendicular to the road and in that case the car is said to have reached the goal once it reaches that line (irrespective of its lateral position in the road).

The likelihood $L(O|G_i)$ for a given goal $G_i \in G$ is defined as the difference between the respective rewards of two plans:

1. an optimal plan from the car's initial location $r_t$ (at time $t$) to the goal location $G_i$, i.e. the optimal plan to get from $r_t$ to $G_i$ irrespective of any observed behaviour of the car after time $t$. This could be executed as a basic maneuver, a macro action or a sequence of multiple basic maneuvers other than a macro action. With multiple basic maneuvers, the partial trajectories associated therewith are combined to provide an optimal full trajectory for reaching the goal $G_i$ from the initial position $r_t$ (irrespective of any actual observed behaviour of the car after time $t$); and

2. a "best available" plan - this is defined as an optimal plan from $r_t$ to the goal location $G_i$ given any observed behaviour of the car between time $t$ and time $t + \Delta t$, i.e. the best plan to get from $r_t$ to $G_i$ with the additional constraint that this plan must match the behaviour actually observed in the subsequent time interval $\Delta T$. In other words, as the optimal plan from the car's initial location $r_t$ to goal $G_i$ such that the plan respects the observations $O$. This assumes that cars are more likely to execute optimal plans to achieve goals but allows for a degree of deviation. This could also be executed as a basic maneuver, a macro action or a sequence of multiple basic maneuvers other than a macro action. With multiple basic maneuvers, the partial trajectories associated therewith are combined to provide a "best available" full trajectory for reaching the goal $G_i$ from the initial position $r_t$ but taking into account the actual observed behaviour of the car in the interval from $t$ to $t + \Delta t$. The best available trajectory has an observed portion for the interval $[t, t + \Delta t]$ which matches the actual observed trajectory and a future portion for a subsequent time interval, chosen so as to minimize an overall reward associated with best available full trajectory (i.e. the full reward of both the observed portion and the future portion).

This is a form of goal recognition because it considers the full path to reach the goal (which may be based on multiple partial trajectories associated with multiple maneuvers).

The reward assigned to a full trajectory can take into account various factors as described later. These include driving time (penalizing trajectories that take longer to reach a goal), safety (penalizing unsafe trajectories) and comfort (e.g. penalizing trajectories with excessive jerk).

The car's initial location $r_t$ may for example be the first observed location of the car. A reasonable approach is to use a moving window of past observations defined by the ego car's sensor ranges to define the initial location $r_t$.

An optimal plan (1 above) is computed for each goal $G_1$, $G_2$ at step 1004 in Figure 10. Once computed, this allows an optimal trajectory to be determined for each goal $G_1$, $G_2$, for example, using an A* search (see below for details). Having computed the optimal trajectory, a full reward associated with the optimal trajectory can then be computed (also described below). The optimal trajectory is a full trajectory, i.e. for reaching the goal in question from the initial location $r_t$.

In the example of Figure 10, trajectories are denoted by points along the trajectory that are evenly spaced in time, such that evenly-spaced points imply constant velocity and increasing (resp. decreasing) distance between points implies acceleration (resp. deceleration). White circles are used to represent optimal trajectory points. It can thus be seen that, for goal $G_1$, the optimal trajectory is a straight-line path continuing along the road at constant speed, whereas for goal $G_2$ the optimal trajectory gradually slows as the car approaches a turning point for the exit.

A best available plan (2 above) is computed for each goal $G_1$, $G_2$ at step 1006. As indicated, these take into account actual observations $O$ between time $t$ (when the car was at its initial location $r_t$) and a current time $t + \Delta t$. Those observations $O$ may comprise the observed low-level trace $\tau$, represented in Figure 10 using black circles.

In that context, the observations $O$ may alternatively or additionally comprise a current maneuver of the car, i.e. the probability of each goal may estimate in dependence on a maneuver currently being executed by the car. They may additionally include past observed maneuvers.

Although not shown explicitly in Figure 10, as described above, probabilistic maneuver detection is applied to predict a probability distribution over possible current maneuvers for the car. Hence, the current maneuver may not be known definitely but only probabilistically, in terms of a distribution $p(M|\tau)$ over possible current maneuvers. In that case, an initial maneuver may be sampled in a similar manner to goals.

From the best available plan, a best available trajectory can be determined (see below for details), which in turn allows a full reward to be determined for the best available trajectory (also described below). This is also a full trajectory in the sense of being a complete trajectory from the initial location $r_t$ to the goal location $G_i$. The best available trajectory has an observed portion between time $t$ and $t + \Delta t$ that matches the actual observed trajectory (i.e. the black circles in Figure 10) and additionally includes a future portion for the time after $t + \Delta T$, represented in Figure 10 using diagonally shaded circles.

In the depicted example, it can be seen that both the observed portion (black circles) and the future portion (diagonally shaded circles) of the best available trajectory for goal $G_1$ match the optimal trajectory (white circles) for that goal $G_1$ reasonably well. Therefore, the reward difference for goal $G_1$ - being the difference between the reward of the optimal trajectory and the reward of the best available trajectory - is relatively low.

However, for goal $G_2$, the observed trajectory (black circles) deviates from the optimal trajectory (white circles) fairly significantly, because the car has failed to by time $t + \Delta t$ to the extent required by the optimal trajectory. This discrepancy will not necessarily cause a significant reward difference *per se* (it may or may not depending on the details of the implementation). However, as a consequence of the observed behaviour, it can be seen that the future portion of the best available trajectory (i.e. the potion after time $t + \Delta t$) must necessarily include sharp braking (which reflects the fact that the highest-reward path from the car's current location to $G_2$ must involve sharp braking given the circumstances of the car) - which is penalized by the reward function. This discrepancy from the reward of the optimal trajectory means a higher reward difference for the goal $G_2$.

At step 1008, for each goal $G_1$, $G_2$, the goal likelihood L(O|G) is computed in terms of the reward difference between the optimal plan computed at step 1004 and the best available plan computed at step 1006 for that goal. This, in turn, allows the goal posterior $P(G|O)$ to be computed (step 1010) based on the goal likelihood and the goal prior.

The prior $P(G)$ can be used to encode knowledge about the "inherent" probability of certain goals. For example, it may be observed, in the scenario of Figure 10, that cars take the right-turn exist relatively infrequently, which could be encoded as a prior with $P(G_2) < P(G_1)$. This would effectively bias goal $G_1$ in favour of $G_2$. For scenarios without this prior knowledge, each goal could simply be assumed to be equally probable absent any observations of a specific car's individual behaviour, i.e. $P(G_1) = P(G_2)$.

The above assumes that, given a goal, an optimal plan for that goal can be determined given the car's initial location $r_t$, and a best available plan for that goal can be determined given the observations in the subsequent time interval $\Delta T$. It moreover assumes that, given an optimal (resp. best available) plan, an optimal (resp. best available) trajectory can be determined. One mechanism for mapping goals to plans to trajectories in this manner uses an A* search, as described above.

References herein to components, functions, modules and the like, denote functional components of a computer system which may be implemented at the hardware level in various ways. A computer system comprises execution hardware which may be configured to execute the method/algorithmic steps disclosed herein and/or to implement a model trained using the present techniques. The term execution hardware encompasses any form/combination of hardware configured to execute the relevant method/algorithmic steps. The execution hardware may take the form of one or more processors, which may be programmable or non-programmable, or a combination of programmable and non-programmable hardware may be used. Examples of suitable programmable processors include general purpose processors based on an instruction set architecture, such as CPUs, GPUs/accelerator processors etc. Such general-purpose processors typically execute computer readable instructions held in memory coupled to or internal to the processor and carry out the relevant steps in accordance with those instructions. Other forms of programmable processors include field programmable gate arrays (FPGAs) having a circuit configuration programmable though circuit description code. Examples of non-programmable processors include application specific integrated circuits (ASICs). Code, instructions etc. may be stored as appropriate on transitory or non-transitory media (examples of the latter including solid state, magnetic and optical storage device(s) and the like). The subsystems 102-108 of the runtime stack Figure 1A may be implemented in programmable or dedicated processor(s), or a combination of both, on-board a vehicle or in an off-board computer system in the context of testing and the like. The various components of Figure 2, such as the simulator 202 and the test oracle 252 may be similarly implemented in programmable and/or dedicated hardware.

## Claims

1. A computer system for testing an autonomous vehicle, AV, stack (100) in simulation, the computer system comprising:

   a trace extraction component (142) configured to processing real-world driving data (140) to extract therefrom at least one observed trace of a real-world agent within a road layout, the observed trace having spatial and motion components;

   a driving scenario extraction component (146) configured to apply at least one of goal recognition (151) and behaviour recognition to the observed trace, to infer a goal or behaviour of the real-world agent within the road layout, and extract a driving scenario defining a version of the road layout and at least one non-ego agent to be simulated, the non-ego agent associated with the inferred goal or behaviour for implementing in simulation within the defined road layout;

a simulator (202) configured to run a simulation based on the extracted driving scenario, in which an ego agent and the non-ego agent each exhibit closed-loop behaviour, wherein the closed-loop behaviour of the ego agent is determined by autonomous decisions taken in the AV stack (100) under testing in response to simulated inputs, reactive to the non-ego agent;

agent decision logic (210) configured to determine the closed-loop behaviour of the non-ego agent in the simulation, by implementing the inferred goal or behaviour, reactive to the ego agent; and

a test oracle configured to evaluate the performance of the AV stack in the simulation, by receiving a simulated ego trace of the ego agent, as generated in the simulation, and scoring the simulated ego trace against a set of predetermined performance metrics.

2. The computer system of claim 1, wherein the test oracle (252) is configured to provide an output comprising a score-time plot (256b) for each performance metric and, wherein the performance metrics are optionally numerical, and the test oracle is configured compare the score-time plot (256b) to a failure threshold.

3. The computer system of claim 1 or 2, wherein the agent decision logic (210) is configured to determine the closed-loop behaviour of the non-ego agent with the aim of matching target motion values along a spatial agent path, but with deviation from the target motion values permitted in reaction to the ego agent, the spatial agent path associated with the inferred goal or behaviour.

4. The computer system of any preceding claim, wherein the driving scenario extraction component (146) is configured to infer the goal or behaviour probabilistically as a distribution over available goals or behaviours, wherein the available goals or behaviours are optionally determined from the road layout.

5. The computer system of any preceding claim, wherein the driving scenario extraction component (146) is configured to infer the goal or behaviour probabilistically by:

determining the set of available goals or behaviours for the real-world agent wherein the available goals or behaviours are optionally determined from the road layout;

for each of the available goals or behaviours, determining an expected trajectory model wherein the expected trajectory model is optionally a single predicted trajectory associated with that goal or behaviour or a distribution of predicted trajectories associated with that goal or behaviour; and

comparing the observed trace of the real-world agent with the expected trajectory model for each of the available goals or behaviours, to determine a likelihood of that goal or behaviour, thus determining a distribution over the available goals or behaviours.

6. The computer system of claim 5, wherein the driving scenario extraction component (146) is configured to use the observed trace to predict a best-available trajectory model for the goal or behaviour, said comparison comprising comparing the best-available trajectory model with the expected trajectory model, wherein a defined reward function is optionally applied to both the expected trajectory model and the best-available trajectory model for each goal, to determine respective rewards of those trajectory models, wherein said comparison comprises comparing those rewards, wherein the reward function optionally rewards reduced driving time whilst penalizing unsafe trajectories.

7. The computer system of any of claims 4 to 6, comprising a sampling component (150) configured to sample a goal or behaviour from the distribution over the possible goals or behaviours, the agent decision logic (210) configured to determine the closed-loop behaviour of the non-ego agent based on the sampled goal or behaviour.

8. The computer system of any preceding claim, comprising a rendering component configured to generate a graphical user interface (500) comprising an output provided by the test oracle for assessing the performance of the AV stack in the simulation.

9. The computer system of any preceding claim, wherein the test oracle is configured to score the simulated ego trace (212a) against the set of predetermined performance metrics in dependence on a simulated non-ego trace (212b) of the non-ego agent and/or in dependence on environmental data of the simulation or other contextual data (214) pertaining to a physical context of the simulation.

10. The computer system of any preceding claim, wherein the trace extraction component (142) is configured to apply one or more non-real time perception algorithms to the real-world driving data (140), in order to extract the observed trace, and wherein the agent decision logic (210) is optionally tuned so as to cause the non-ego agent to realize a trajectory that substantially corresponds to the observed trace in the event the behaviour of the ego agent in the simulation substantially matches the behaviour of a real ego agent in the real-world driving data (140).

11. A computer-implemented method of testing an autonomous vehicle, AV, stack in simulation, the method comprising:

running, in a simulator (202), a simulation based on an extracted driving scenario, in which an ego agent and at least one non-ego agent each exhibit closed-loop behaviour, wherein the closed-loop behaviour of the ego agent is determined by autonomous decisions taken in the AV stack (100) under testing in response to simulated inputs, reactive to the non-ego agent, wherein the closed-loop behaviour of the non-ego agent is determined by implementing an inferred goal or behaviour, reactive to the ego agent; and

evaluating, by a test oracle, the performance of the AV stack in the simulation, by receiving an ego trace of the ego agent, as generated in the simulation, and scoring the ego trace against a set of predetermined performance metrics; and

the driving scenario having been extracted from real-world driving data (140) captured within a road layout, by: processing the real-world driving data (140) to extract at least one observed trace of a real-world agent, the observed trace having spatial and motion components, applying at least one of goal recognition and behaviour recognition to the observed trace, to infer the goal or behaviour of the real-world agent within the road layout, the extracted driving scenario defining a version of the road layout and at least one non-ego agent to be simulated, the non-ego agent associated with the inferred goal or behaviour for implementing in simulation within the defined version of the road layout.

12. The method of claim 11, comprising:
using an output provided by the test oracle to identify and mitigate a performance issue within the AV stack under testing, the output for assessing the performance of the AV stack in the simulation.

13. The method of claim 12, wherein the AV stack (100) comprises at least one trainable machine learning component, the method performed multiple times as part of a structured training process, wherein the performance of the AV stack (100) is evaluated in each simulation, and that evaluation is used to train parameters of the machine learning component wherein the structured training process is optionally a reinforcement learning process, in which the parameters are trained based on a training cost or reward function applied to each simulation.

14. A computer program comprising program instructions for programming a computer system to implement the method of any of claims 11 to 13.

**Patentansprüche**

1. Ein Computersystem zum Testen eines autonomen Fahrzeugstapels AV (100) in Simulation, wobei das Computersystem umfasst:

eine Spur-Extraktionskomponente (142), die dazu eingerichtet ist, reale Fahrdaten (140) zu verarbeiten, um daraus mindestens eine beobachtete Spur eines realen Agenten innerhalb eines Straßenlayouts zu extrahieren, wobei die beobachtete Spur räumliche und Bewegungsbestandteile aufweist;

eine Fahrtszenario-Extraktionskomponente (146), die dazu eingerichtet ist, mindestens eine der Zielerkennung (151) und Verhaltenskennung auf die beobachtete Spur anzuwenden, um ein Ziel oder Verhalten des realen Agenten innerhalb des Straßenlayouts zu erkennen und ein Fahrtszenario zu extrahieren, das eine Version des Straßenlayouts und mindestens einen Nicht-Ego-Agenten definiert, der simuliert werden soll, wobei der Nicht-Ego-Agent mit dem erkannten Ziel oder Verhalten für die Implementierung in der Simulation innerhalb des definierten Straßenlayouts verbunden ist;

einen Simulator (202), der dazu eingerichtet ist, eine Simulation basierend auf dem extrahierten Fahrtszenario durchzuführen, in der ein Ego-Agent und der Nicht-Ego-Agent jeweils ein geschlossenes Regelverhalten zeigen, wobei das geschlossene Regelverhalten des Ego-Agenten durch autonome Entscheidungen bestimmt wird, die im zu testenden AV-Stapel (100) als Reaktion auf simulierte Eingaben getroffen werden, die auf den Nicht-Ego-Agenten reagieren;

eine Agenten-Entscheidungslogik (210), die dazu eingerichtet ist, das geschlossene Regelverhalten des Nicht-Ego-Agenten in der Simulation zu bestimmen, indem das erkannte Ziel oder Verhalten implementiert wird, das auf den Ego-Agenten reagiert; und

EP 4 150 465 B1

ein Testorakel, das dazu eingerichtet ist, die Leistung des AV-Stapels in der Simulation zu bewerten, indem es eine simulierte Ego-Spur des Ego-Agenten empfängt, wie sie in der Simulation erzeugt wurde, und die simulierte Ego-Spur anhand einer Reihe vorbestimmter Leistungsmetriken bewertet.

2. Das Computersystem nach Anspruch 1, wobei das Testorakel (252) dazu eingerichtet ist, eine Ausgabe bereitzustellen, die ein Punkt-Zeit-Diagramm (256b) für jede Leistungsmetrik umfasst, und wobei die Leistungsmetriken optional numerisch sind und das Testorakel dazu eingerichtet ist, das Punkt-Zeit-Diagramm (256b) mit einem Fehlergrenzwert zu vergleichen.

3. Das Computersystem nach Anspruch 1 oder 2, wobei die Agenten-Entscheidungslogik (210) dazu eingerichtet ist, das geschlossene Regelverhalten des Nicht-Ego-Agenten mit dem Ziel zu bestimmten, Zielbewegungswerte entlang eines räumlichen Agentenpfads zu erreichen, wobei jedoch Abweichungen von den Zielbewegungswerten in Reaktion auf den Ego-Agenten erlaubt sind, wobei der räumliche Agentenpfad mit dem erkannten Ziel oder Verhalten verbunden ist.

4. Das Computersystem nach einem der vorhergehenden Ansprüche, wobei die Fahrtszenario-Extraktionskomponente (146) dazu eingerichtet ist, das Ziel oder Verhalten probabilistisch als Verteilung über verfügbare Ziele oder Verhaltensweisen zu erkennen, wobei die verfügbaren Ziele oder Verhaltensweisen optional aus dem Straßenlayout bestimmt werden.

5. Das Computersystem nach einem der vorhergehenden Ansprüche, wobei die Fahrtszenario-Extraktionskomponente (146) dazu eingerichtet ist, das Ziel oder Verhalten probabilistisch zu erkennen durch:

Bestimmen der Menge verfügbarer Ziele oder Verhaltensweisen für den realen Agenten, wobei die verfügbaren Ziele oder Verhaltensweisen optional aus dem Straßenlayout bestimmt werden;
für jedes der verfügbaren Ziele oder Verhaltensweisen ein erwartetes Trajektorienmodell bestimmen, wobei das erwartete Trajektorienmodell optional eine einzelne vorhergesagte Trajektorie ist, die mit diesem Ziel oder Verhalten verbunden ist, oder eine Verteilung vorhergesagter Trajektorien, die mit diesem Ziel oder Verhalten verbunden sind; und
Vergleichen der beobachteten Spur des realen Agenten mit dem erwarteten Trajektorienmodell für jedes der verfügbaren Ziele oder Verhaltensweisen, um eine Wahrscheinlichkeit für dieses Ziel oder Verhalten zu bestimmen, wodurch eine Verteilung über die verfügbaren Ziele oder Verhaltensweisen bestimmt wird.

6. Das Computersystem nach Anspruch 5, wobei die Fahrtszenario-Extraktionskomponente (146) dazu eingerichtet ist, die beobachtete Spur zu verwenden, um ein bestverfügbares Trajektorienmodell für das Ziel oder Verhalten vorherzusagen, wobei der Vergleich das Vergleichen des bestverfügbaren Trajektorienmodells mit dem erwarteten Trajektorienmodell umfasst, wobei eine definierte Belohnungsfunktion optional sowohl auf das erwartete Trajektorienmodell als auch auf das bestverfügbare Trajektorienmodell für jedes Ziel angewendet wird, um die jeweiligen Belohnungen dieser Trajektorienmodelle zu bestimmen, wobei der Vergleich das Vergleichen dieser Belohnungen umfasst, wobei die Belohnungsfunktion optional reduzierte Fahrzeit belohnt und unsichere Trajektorien bestraft.

7. Das Computersystem nach einem der Ansprüche 4 bis 6, umfassend eine Abtastkomponente (150), die dazu eingerichtet ist, ein Ziel oder Verhalten aus der Verteilung über die möglichen Ziele oder Verhaltensweisen abzutasten, wobei die Agenten-Entscheidungslogik (210) dazu eingerichtet ist, das geschlossene Regelverhalten des Nicht-Ego-Agenten basierend auf dem abgetasteten Ziel oder Verhalten zu bestimmen.

8. Das Computersystem nach einem der vorhergehenden Ansprüche, umfassend eine Rendering-Komponente, die dazu eingerichtet ist, eine grafische Benutzeroberfläche (500) zu erzeugen, die eine vom Testorakel bereitgestellte Ausgabe zur Bewertung der Leistung des AV-Stapels in der Simulation umfasst.

9. Das Computersystem nach einem der vorhergehenden Ansprüche, wobei das Testorakel dazu eingerichtet ist, die simulierte Ego-Spur (212a) anhand der Reihe vorbestimmter Leistungsmetriken in Abhängigkeit von einer simulierten Nicht-Ego-Spur (212b) des Nicht-Ego-Agenten und/oder in Abhängigkeit von Umweltdaten der Simulation oder anderen Kontextdaten (214), die sich auf einen physischen Kontext der Simulation beziehen, zu bewerten.

10. Das Computersystem nach einem der vorhergehenden Ansprüche, wobei die Spur-Extraktionskomponente (142) dazu eingerichtet ist, ein oder mehrere nichtechtzeitliche Wahrnehmungsalgorithmen auf die realen Fahrdaten (140) anzuwenden, um die beobachtete Spur zu extrahieren, und wobei die Agenten-Entscheidungslogik (210) optional so abgestimmt ist, dass sie den Nicht-Ego-Agenten dazu veranlasst, eine Trajektorie zu realisieren, die im Wesentlichen der beobachteten Spur entspricht, falls das Verhalten des Ego-Agenten in der Simulation im Wesentlichen dem Verhalten eines realen Ego-Agenten in den realen Fahrdaten (140) entspricht.

**11.** Ein computerimplementiertes Verfahren zum Testen eines autonomen Fahrzeugstapels AV in Simulation, wobei das Verfahren umfasst:

Ausführen einer Simulation in einem Simulator (202) basierend auf einem extrahierten Fahrtszenario, in dem ein Ego-Agent und mindestens ein Nicht-Ego-Agent jeweils ein geschlossenes Regelverhalten zeigen, wobei das geschlossene Regelverhalten des Ego-Agenten durch autonome Entscheidungen bestimmt wird, die im zu testenden AV-Stapel (100) als Reaktion auf simulierte Eingaben getroffen werden, die auf den Nicht-Ego-Agenten reagieren, wobei das geschlossene Regelverhalten des Nicht-Ego-Agenten durch Implementierung eines erkannten Ziels oder Verhaltens bestimmt wird, das auf den Ego-Agenten reagiert; und

Bewerten der Leistung des AV-Stapels in der Simulation durch ein Testorakel, indem eine Ego-Spur des Ego-Agenten empfangen wird, wie sie in der Simulation erzeugt wurde, und die Ego-Spur anhand einer Reihe vorbestimmter Leistungsmetriken bewertet wird; und das Fahrtszenario aus realen Fahrdaten (140), die innerhalb eines Straßenlayouts erfasst wurden, extrahiert wurde, indem: die realen Fahrdaten (140) verarbeitet werden, um mindestens eine beobachtete Spur eines realen Agenten zu extrahieren, wobei die beobachtete Spur räumliche und Bewegungsbestandteile aufweist, mindestens eine der Zielerkennung und Verhaltenserkennung auf die beobachtete Spur angewendet wird, um das Ziel oder Verhalten des realen Agenten innerhalb des Straßenlayouts zu erkennen, das extrahierte Fahrtszenario eine Version des Straßenlayouts und mindestens einen Nicht-Ego-Agenten definiert, der simuliert werden soll, wobei der Nicht-Ego-Agent mit dem erkannten Ziel oder Verhalten für die Implementierung in der Simulation innerhalb der definierten Version des Straßenlayouts verbunden ist.

**12.** Das Verfahren nach Anspruch 11, umfassend:
Verwenden einer vom Testorakel bereitgestellten Ausgabe, um ein Leistungsproblem im zu testenden AV-Stapel zu identifizieren und zu beheben, wobei die Ausgabe zur Bewertung der Leistung des AV-Stapels in der Simulation dient.

**13.** Das Verfahren nach Anspruch 12, wobei der AV-Stapel (100) mindestens eine trainierbare maschinelle Lernkomponente umfasst, das Verfahren mehrmals als Teil eines strukturierten Trainingsprozesses durchgeführt wird, wobei die Leistung des AV-Stapels (100) in jeder Simulation bewertet wird, und diese Bewertung verwendet wird, um Parameter der maschinellen Lernkomponente zu trainieren, wobei der strukturierte Trainingsprozess optional ein Verstärkungslernprozess ist, bei dem die Parameter basierend auf einer Trainingskosten- oder Belohnungsfunktion, die auf jede Simulation angewendet wird, trainiert werden.

**14.** Ein Computerprogramm, das Programmierbefehle zum Programmieren eines Computersystems umfasst, um das Verfahren nach einem der Ansprüche 11 bis 13 zu implementieren.

## Revendications

**1.** Système informatique permettant de tester une pile de véhicule autonome (AV) (100) en simulation, le système informatique comprenant :

un composant d'extraction de trace (142) configuré pour traiter des données de conduite du monde réel (140) afin d'en extraire au moins une trace observée d'un agent du monde réel dans un tracé de route, la trace observée ayant des composantes spatiales et de mouvement ;

un composant d'extraction de scénario de conduite (146) configuré pour appliquer au moins une reconnaissance parmi une reconnaissance d'objectif (151) et une reconnaissance de comportement, à la trace observée afin de déduire un objectif ou un comportement de l'agent du monde réel dans le tracé de route, et configuré pour extraire un scénario de conduite définissant une version du tracé de route et au moins un non-ego-agent à simuler, le non-ego-agent étant associé à l'objectif déduit ou au comportement déduit pour permettre la mise en œuvre en simulation dans le tracé de route défini ;

un simulateur (202) configuré pour exécuter une simulation sur la base du scénario de conduite extrait, dans lequel un ego-agent et le non-ego-agent présentent chacun un comportement en boucle fermée, dans lequel le comportement en boucle fermée de l'ego-agent est déterminé par des décisions autonomes prises dans la pile de AV (100) en cours de test en réponse à des entrées simulées, en réaction au non-ego-agent ;

une logique de décision d'agent (210) configurée pour déterminer le comportement en boucle fermée du non-ego-agent lors de la simulation, en mettant en œuvre l'objectif déduit ou le comportement déduit, en réaction à l'ego-agent; et

un oracle de test configuré pour évaluer la performance de la pile de AV lors de la simulation, en recevant une ego-trace simulée de l'ego-agent, telle que générée lors de la simulation, et en donnant une note à l'ego-trace simulée en fonction d'un ensemble de mesures de performance prédéterminées.

2. Système informatique selon la revendication 1, dans lequel l'oracle de test (252) est configuré pour fournir une sortie comprenant une représentation graphique du score en fonction du temps (256b) pour chaque mesure de performance, et dans lequel les mesures de performance sont éventuellement numériques et l'oracle de test est configuré pour comparer la représentation graphique du score en fonction du temps (256b) à un seuil de défaillance.

3. Système informatique selon la revendication 1 ou 2, dans lequel la logique de décision d'agent (210) est configurée pour déterminer le comportement en boucle fermée du non-ego-agent dans le but de faire correspondre des valeurs de mouvement cibles le long d'un chemin d'agent spatial, mais avec un écart par rapport aux valeurs de mouvement cibles autorisé en réaction à l'ego-agent, le chemin d'agent spatial étant associé à l'objectif déduit ou au comportement déduit.

4. Système informatique selon l'une quelconque des revendications précédentes, dans lequel le composant d'extraction de scénario de conduite (146) est configuré pour déduire l'objectif ou le comportement de manière probabiliste sous la forme d'une distribution sur des objectifs disponibles ou des comportements disponibles, dans lequel les objectifs disponibles ou les comportements disponibles sont éventuellement déterminés à partir du tracé de route.

5. Système informatique selon l'une quelconque des revendications précédentes, dans lequel le composant d'extraction de scénario de conduite (146) est configuré pour déduire l'objectif ou le comportement de manière probabiliste en :

déterminant l'ensemble des objectifs disponibles ou des comportements disponibles pour l'agent du monde réel, dans lequel les objectifs disponibles ou les comportements disponibles sont éventuellement déterminés à partir du tracé de route ;

pour chacun des objectifs disponibles ou des comportements disponibles, déterminant un modèle de trajectoire attendue, dans lequel le modèle de trajectoire attendue est éventuellement une unique trajectoire prédite associée à cet objectif ou à ce comportement ou à une distribution de trajectoires prédites associées à cet objectif ou à ce comportement ; et

comparant la trace observée de l'agent du monde réel avec le modèle de trajectoire attendue pour chacun des objectifs disponibles ou des comportements disponibles afin de déterminer une probabilité de cet objectif ou de ce comportement, déterminant ainsi une distribution sur les objectifs disponibles ou sur les comportements disponibles.

6. Système informatique selon la revendication 5, dans lequel le composant d'extraction de scénario de conduite (146) est configuré pour utiliser la trace observée afin de prédire un modèle de la meilleure trajectoire disponible pour l'objectif ou pour le comportement, ladite comparaison consistant à comparer le modèle de la meilleure trajectoire disponible avec le modèle de trajectoire attendue, dans lequel une fonction de récompense définie est éventuellement appliquée à la fois au modèle de trajectoire attendue et au modèle de la meilleure trajectoire disponible pour chaque objectif afin de déterminer des récompenses respectives de ces modèles de trajectoire, dans lequel ladite comparaison consiste à comparer ces récompenses, dans lequel la fonction de récompense récompense éventuellement un temps de conduite réduit tout en pénalisant des trajectoires dangereuses.

7. Système informatique selon l'une quelconque des revendications 4 à 6, comprenant un composant d'échantillonnage (150) configuré pour échantillonner un objectif ou un comportement à partir de la distribution sur les objectifs possibles ou sur les comportements possibles, la logique de décision d'agent (210) étant configurée pour déterminer le comportement en boucle fermée du non-ego-agent sur la base de l'objectif échantillonné ou du comportement échantillonné.

8. Système informatique selon l'une quelconque des revendications précédentes, comprenant un composant de rendu configuré pour générer une interface d'utilisateur graphique (500) comprenant une sortie fournie par l'oracle de test à des fins d'évaluation de la performance de la pile de AV lors de la simulation.

9. Système informatique selon l'une quelconque des revendications précédentes, dans lequel l'oracle de test est configuré pour donner une note à l'ego-trace simulée (212a) en fonction de l'ensemble de mesures de performance prédéterminées selon une non-ego-trace simulée (212b) du non-ego-agent et/ou selon des données environnementales de la simulation ou d'autres données contextuelles (214) relatives à un contexte physique de la simulation.

10. Système informatique selon l'une quelconque des revendications précédentes, dans lequel le composant d'extraction de trace (142) est configuré pour appliquer un ou plusieurs algorithmes de perception en temps non réel aux données de conduite du monde réel (140) afin d'extraire la trace observée, et dans lequel la logique de décision d'agent (210) est éventuellement réglée de manière à amener le non-ego-agent à réaliser une trajectoire qui correspond sensiblement à la trace observée dans le cas où le comportement de l'ego-agent lors de la simulation correspond sensiblement au comportement d'un ego-agent réel dans les données de conduite du monde réel (140).

11. Procédé mis en œuvre par ordinateur pour tester une pile de véhicule autonome (AV) en simulation, le procédé consistant à :

exécuter, dans un simulateur (202), une simulation basée sur un scénario de conduite extrait dans lequel un ego-agent et au moins un non-ego-agent présentent chacun un comportement en boucle fermée, le comportement en boucle fermée de l'ego-agent étant déterminé par des décisions autonomes prises dans la pile de AV (100) en cours de test en réponse à des entrées simulées, en réaction au non-ego-agent, le comportement en boucle fermée du non-ego-agent étant déterminé en mettant en œuvre un objectif déduit ou un comportement déduit, en réaction à l'ego-agent ; et

évaluant, par un oracle de test, la performance de la pile de AV lors de la simulation, en recevant une ego-trace de l'ego-agent, telle que générée lors de la simulation, et en donnant une note à l'ego-trace en fonction d'un ensemble de mesures de performance prédéterminées, et

le scénario de conduite ayant été extrait à partir de données de conduite du monde réel (140) capturées dans un tracé de route, en : traitant les données de conduite du monde réel (140) afin d'extraire au moins une trace observée d'un agent du monde réel, la trace observée ayant des composantes spatiales et de mouvement ; appliquant au moins une reconnaissance parmi une reconnaissance d'objectif et une reconnaissance de comportement, à la trace observée afin de déduire l'objectif ou le comportement de l'agent du monde réel dans le tracé de route, le scénario de conduite extrait définissant une version du tracé de route et au moins un non-ego-agent à simuler, le non-ego-agent étant associé à l'objectif déduit ou au comportement déduit pour permettre la mise en œuvre en simulation dans la version définie du tracé de route.

12. Procédé selon la revendication 11, consistant à :
utiliser une sortie fournie par l'oracle de test afin d'identifier et d'atténuer un problème de performance dans la pile de AV en cours de test, la sortie permettant d'évaluer la performance de la pile de AV lors de la simulation.

13. Procédé selon la revendication 12, dans lequel la pile de AV (100) comprend au moins un composant d'apprentissage automatique pouvant être entraîné, le procédé étant effectué plusieurs fois dans le cadre d'un processus d'entraînement structuré, dans lequel la performance de la pile de AV (100) est évaluée lors de chaque simulation et cette évaluation est utilisée pour entraîner des paramètres du composant d'apprentissage automatique, le processus d'entraînement structuré étant éventuellement un processus d'apprentissage par renforcement dans lequel les paramètres sont entraînés sur la base d'une fonction de coût d'entraînement ou de récompense d'entraînement appliquée à chaque simulation.

14. Programme informatique, comprenant des instructions de programme destinées à programmer un système informatique pour qu'il mette en œuvre le procédé selon l'une quelconque des revendications 11 à 13.

Sensors
110

Runtime stack 100

Perception
102

Prediction
104

Planning
106

Control
108

Actor system
112

FIG. 1A

FIG. 1B

EP 4 150 465 B1

FIG. 1C

FIG.2

FIG.2A

EP 4 150 465 B1

Rule Tree

Derived Signal
+
results

Accessor ........ 304a

Derived Signal
+
results

Derived Signal
+
results

........ 304

........ 300

Assessor

Assessor

Signal

Signal

Signal

Extractor

Extractor

Extractor

........ 302

Traces
(212)

Contextual (214)

........ 310

Scenario data

## FIG.3A

Derived Signal

........ 312

........ 316

Results

........ 314

Time

## FIG.3B

FIG.4A

FIG.4B

252

Test Oracle

Rule evaluation ~424

Rule activation ~422

254

Performance evaluation rules

400

Rule editor

Scenario ground truth 310

# FIG. 4C

Test Oracle

256

258

252

Visualization

520

Display

GUI 500

522

# FIG.5

FIG.5A

EP 4 150 465 B1

## FIG.5B

Pass
Fail
Inactive

## FIG.5C

FIG.6A

EP 4 150 465 B1

FIG.6B

Scenario Ground Truth — 310a

Test Oracle — 252

Time

Other agent moving in adjacent lane
Other agent breaches

Scenario terminates with collision event

Test Results — 256a

Agent n

collision:
is_d_safe:
is_longd_safe:
is_latd_safe:

Pass
Fail
Inactive

t0  t1  t2  Time

FIG.6C

EP 4 150 465 B1

FIG. 6D

EP 4 150 465 B1

For each agent:

Hypothesise possible goals from context — SB2

For each hypothesised goal:

Synthesis a set of $n$ predicted paths for that goal — SB4

Match observed trace to path distribution for that goal to determine likelihood of goal — SB6

# FIG. 7

FIG. 8A

FIG. 8B

FIG. 9

Given initial location $r_t$ and goal location $G_i$ for each goal:

compute optimal plan from initial location $r_t$ to goal location $G_i$ and cost of optimal plan

1004

compute optimal plan from initial location $r_t$ to goal location $G_i$ taking into account actual observations O between t and t+Δt ("best available" plan) and cost of best available plan

1006

1008

For each goal, compute goal likelihood L(O|G) in terms of cost penalty, i.e. difference between cost of optimal plan and cost of best available plan for each goal

Compute goal posterior P(G|O) based on goal likelihood L(O|G) and goal prior P(G)

1010

$G_2$

$r_t$

$G_1$

$G_2$

$r_t$

straight line at constant speed

$G_1$

$G_2$

$r_t$

straight line gradually slowing as turning point approached

Future

Past

$r_{t+\Delta t}$

$r_t$

$G_1$

$G_2$

straight line at constant speed

$r_{t+\Delta t}$

$r_t$

$G_1$

$G_2$

straight line gradually slowing as turning point approached

Best available plan close to optimal plan

Aggressive braking to reach $G_2$ unavoidable

Low cost penalty

High cost penalty because of resulting deviation from optimal plan

Key:

◯ = optimal plan for goal
● = actual observations
⊘ = best-available plan for goal given observations

# FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020079069 A
- WO 2020079066 A
- WO 2021073781 A
- WO 2021037763 A

- WO 2021037760 A
- WO 2021037765 A
- WO 2021037761 A
- WO 2021037766 A

**Non-patent literature cited in the description**

- **SHALEV-SHWARTZ et al.** On a Formal Model of Safe and Scalable Self-driving Cars. *arXiv:1708.06374*, 2017
- Integrating Planning and Interpretable Goal Recognition for Autonomous Driving. **STEFANO V ALBRECHT et al.** ARXIV.ORG. CORNELL UNIVERSITY LIBRARY, 06 February 2020
- Multipolicy decision-making for autonomous driving via changepoint-based behavior prediction: Theory and experiment. **GALCERAN ENRIC et al.** AUTONOMOUS ROBOTS. KLUWER ACADEMIC PUBLISHERS, 09 February 2017, vol. 41, 1367-1382
- **C. G'AMEZ SERNA** ; **Y. RUICHEK**. Dynamic speed adap-tation for path tracking based on curvature information and speed limits.. *Sensors*, 2017, vol. 17 (1383)

- **P. HART** ; **N. NILSSON** ; **B. RAPHAEL**. A formal basis for the heuristic determination of minimum cost paths.. *In IEEE Transactions on Systems Science and Cybernetics*, July 1968, vol. 4, 100-107
- Online Bayesian changepoint detection for articulated motion models. **S. NIEKUM** ; **S. OSENTOSKI** ; **C. ATKESON** ; **A. BARTO**. IEEE International Conference on Robotics and Automation.. IEEE, 2015
- **A. WACHTER** ; **L. BIEGLER**. On the implementation of an interior-point filter line-search algorithm for large-scale nonlinear programming.. *Mathematical Programming*, 2006, vol. 106 (1), 25-57
- **HEKMATNEJAD et al.** Encoding and Monitoring Responsibility Sensitive Safety Rules for Automated Vehicles in Signal Temporal Logic. *MEMOCODE '19: Proceedings of the 17th ACM-IEEE International Conference on Formal Methods and Models for System Design*, 2019